# EUROPEAN PATENT SPECIFICATION

(11) **EP 4 468 128 B1**
(45) Date of publication and mention of the grant of the patent: **22.07.2026**
(21) Application number: 24177669.9
(22) Date of filing: 23.05.2024
(51) Int. Cl.: G06F 3/041, G06F 3/044

(54) **TOUCH INPUT DEVICE**
BERÜHRUNGSEINGABEVORRICHTUNG
DISPOSITIF D'ENTRÉE TACTILE

(30) Priority: 26.05.2023 KR 20230068442
(43) Date of publication of application: 27.11.2024
(73) Proprietor: HiDeep Inc., Seongnam-si, Gyeonggi-do 13493 (KR)
(72) Inventor: CHO, Youngho, 13493 Seongnam-si (KR); KIM, Seyeob, 13493 Seongnam-si (KR); KIM, Bonkee, 13493 Seongnam-si (KR)
(74) Representative: HGF

(56) References cited:
- EP-A1- 3 306 446
- US-A1- 2013 257 785
- US-A1- 2014 160 041
- US-A1- 2015 185 913
- US-A1- 2016 306 456
- US-A1- 2016 370 915
- US-A1- 2019 102 002
- US-A1- 2022 057 897

## Description

### BACKGROUND

Various types of input devices are used to manipulate a computing system. For example, input devices such as buttons, keys, joysticks, and touch screens are used. Due to an easy and convenient operation of a touch screen, use of the touch screen is increasing when operating the computing system.

A touch sensor is a type of information input device, and the touch sensor may be provided and used in a display panel. For example, the touch sensor may be attached to one surface of a display panel, or the touch sensor may be manufactured integrally with the display panel. A user may input information by touching the touch sensor while viewing an image displayed on the screen of the display panel.

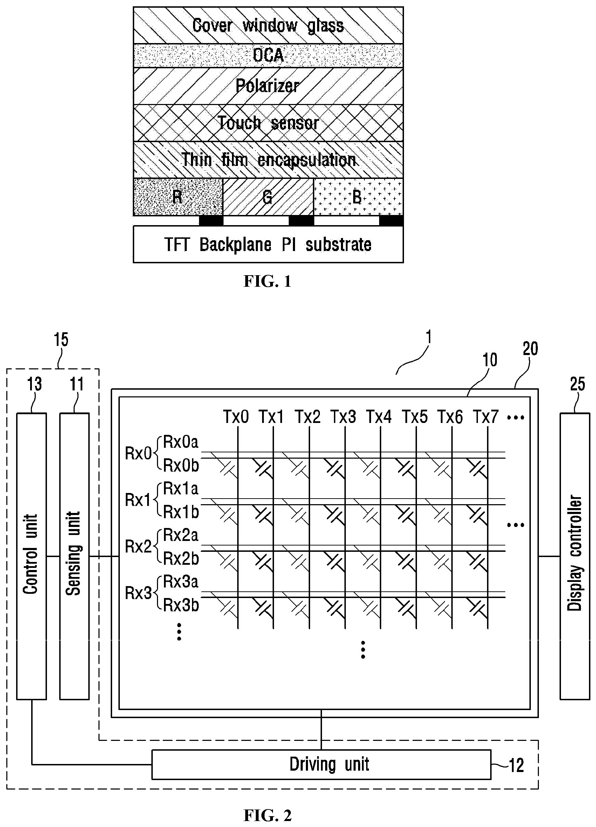

FIG. 1 is a schematic diagram showing a conventional laminated structure of the OCTA technology.

The OCTA, a type of touch screen panel technology, is an abbreviation of On Cell Touch AMOLED. As shown in FIG. 1, the OCTA is a type of TSP (Touch Screen Panel) technology in which a touch sensor is directly deposited on an AMOLED display cell. In other words, it is a technology that internalizes a smartphone/tablet touchscreen function into an OLED panel. Since there is no tempered glass between a cell and an electrode, it increases clarity compared to an existing general TSP.

Y-OCTA is a touch screen panel in which a touch sensor is directly deposited on a cell. Y-OCTA is named by attaching Y, from 'YOUM' of Samsung Display's flexible OLED brand name to the 'OCTA'. The Y-OCTA technology is applied to a Thin Film Encapsulation (TFE) process during an OLED manufacturing process. A touch screen is implemented by patterning an aluminum metal mesh sensor used as a touch sensor between an organic material for thin film encapsulation and a polarizer. According to the Y-OCTA, by attaching a polarizer closely to a cover window, a visibility problem occurring at a curved edge may be solved. In addition, by removing a support film, a panel thickness may be reduced. Since a laminating process may be omitted, costs may be reduced.

A conventional touch input device having a Y-OCTA touch screen panel has a problem in a Low Ground Mass (LGM) state. An LGM problem is a phenomenon in which a driving electrode and a receiving electrode are implemented as a single layer or a double layer in a touch sensor when a certain touch occurs in a state in which a user does not hold a touch input device equipped with the touch sensor by hand (so-called 'floating state'), a signal to be detected normally disappears from a point of view of the touch input device, or a signal to be detected normally is split and detected as if being touched at two or more points.

In addition, a conventional touch input device having a Y-OCTA touch screen panel has a flicker problem in a display panel according to driving of the touch sensor. The flicker problem is a phenomenon in which a display screen flickers or vibrates very quickly caused by various causes.

To solve this flicker problem, conventional attempts have been performed such as an attempt using dithering for each frame, using a lower driving voltage of the touch sensor, and another attempt using a received frame rate information from a display driving chip (DDI) during VRR (Variable Refresh Rate) operation and changing a frequency of a driving signal of the touch sensor accordingly. However, these attempts do not completely solve the flicker problem.
EP3306446A1 relates to a display device integrated with touch function and a driving method thereof. The disclosure aims to prolong the charging time for the display pixels.
US2019102002A1 relates to a touch sensing apparatus including a first electrode and a second electrode; a driver configured to apply a driving signal to the first electrode; a touch sensor configured to receive a signal transferred depending on the driving signal from the second electrode, and to convert and output the signal as a sensing signal; and a touch controller configured to detect the sensing signal.
US2013257785A1 relates to a mutual capacitance touch panel device which includes a substrate and an array of electrode elements formed on the substrate, each electrode element including a drive electrode and a pair of dual-function electrodes.
US2022057897A1 relates to a touch screen which can include touch electrodes that can function as drive (Tx) electrodes and sense (Rx) electrodes during a touch sensing operation of the electronic device.
US2016306456A1 relates to a capacitive touch sensor which includes an array of electrode elements, each electrode element including a drive electrode and a sense electrode, the drive electrode and the sense electrode forming at least one mutual coupling capacitor in each electrode element.

### SUMMARY

The extent of protection conferred is determined by the claims.

The present invention provides a touch input device capable of minimizing a display noise caused by driving of a display panel.

The present invention also provides a touch input device capable of minimizing a flicker effect that may occur on a display panel by driving of a touch sensor.

The present invention also provides a touch input device capable of improving a touch malfunction in an LGM state.

A touch input device including a display panel according to an embodiment of the present invention includes: a touch sensor including a plurality of first electrodes and a plurality of second electrodes disposed to cross the plurality of first electrodes; and a touch controller electrically connected to the plurality of first electrodes and the plurality of second electrodes to control the touch sensor. Here, the second electrode includes a pair of electrode portions, one of the pair of electrode portions is disposed adjacent to at least one of the electrodes among the plurality of first electrodes, and the other of the pair of electrode portions is disposed adjacent to at least one of remaining electrodes among the plurality of first electrodes. The touch controller controls to apply at least one driving signal to the plurality of second electrodes and receive sensing signals from the plurality of first electrodes. The touch controller comprises a driving circuit unit electrically connected to the plurality of second electrodes. The driving circuit unit comprises: a driving driver configured to amplify the driving signal and output the amplified signal to the one of the pair of electrode portions of the second electrode; a first switch element configured to electrically connect or open the one of the pair of electrode portions and the other of the pair electrode portions; a second switch element connected between the driving driver and the one of the pair of electrode portions; a third switch element connected to the one of the pair of electrode portions; and a receive analog front end connected to the third switch element.
Also, the touch controller may be configured to drive the touch sensor in synchronization with at least one horizontal synchronization signal applied to the display panel and drive the touch sensor for a predetermined time after the horizontal synchronization signal starts to be applied to the display panel.

The touch controller may be configured to drive the touch sensor in a time interval different from a time interval in which horizontal synchronization signals are applied to the display panel.

Here, the touch controller may control a touch report rate of the touch sensor to be the same as a display refresh rate of the display panel.

Here, the touch controller may control a touch report rate of the touch sensor to be higher than a display refresh rate of the display panel.

Here, the touch input device may further include a display controller controlling driving of the display panel. Also, the display controller may drive the display panel by dividing the entire time interval in which the horizontal synchronization signals are applied into at least two time intervals, and the touch controller may drive the touch sensor in a predetermined time interval between the two time intervals.

Here, the touch controller may: receive a vertical synchronization signal applied to the display panel; generate at least one internal signal having a frequency corresponding to 1/N times (N is a natural number) of a frequency of the received vertical synchronization signal; and control a timing of a driving signal for driving the touch sensor based on the generated internal signal.

Here, the touch controller may control by dividing a time for driving the touch sensor and a time for driving or/and receiving a stylus within a predetermined time interval between the two time intervals.

Here, the touch controller may control a stylus report rate of the stylus to be N times (N is a natural number greater than 1) faster than the touch report rate.

Here, the touch controller may control to apply at least one driving signal to the plurality of first electrodes and receive sensing signals from the plurality of second electrodes.

Here, the touch controller may include a receiving circuit unit electrically connected to the plurality of second electrodes, and the receiving circuit unit may include a differential amplifier having a pair of input terminals electrically connected to the pair of electrode portions of the second electrode.

Here, the touch controller may include a receiving circuit unit electrically connected to the plurality of second electrodes, and the receiving circuit unit may include: a pair of amplifiers having input terminals electrically connected to the pair of electrode portions of the second electrode, respectively; and a signal processing unit electrically connected to output terminals of the pair of amplifiers to output a differential signal.

Here, the touch controller may include a receiving circuit unit electrically connected to the plurality of second electrodes, and the receiving circuit unit may include: a plurality of amplifiers having input terminals electrically connected to the pair of electrode portions of the plurality of second electrodes, respectively; and a signal processing unit electrically connected to output terminals of two adjacent amplifiers among the plurality of amplifiers to output a differential signal.

Here, the touch controller may include a receiving circuit unit electrically connected to the plurality of second electrodes, and the receiving circuit unit may include a first switch element configured to electrically connect or open the pair of electrode portions of each of the second electrodes.

Here, the receiving circuit unit may further include: a second switch element connected to one end of the first switch element; a third switch element connected to the other end of the first switch element; a fourth switch element connected between the second switch element and an AC ground; and a fifth switch element connected between the third switch element and the AC ground.

Here, the touch controller may include a receiving circuit unit electrically connected to the plurality of second electrodes, and the receiving circuit unit may include: a plurality of switching units electrically connected to the pair of electrode portions of the second electrode to electrically connect or open the pair of electrode portions to each other; a multiplexer configured to output two signals selected from among signals output from the plurality of switching units; and a differential amplifier configured to differentially amplify the two signals output from the multiplexer and output the differentially amplified signals.
A touch input device including a display panel according to another embodiment of the present invention includes: a touch sensor including a plurality of first electrodes and a plurality of second electrodes disposed to cross the plurality of first electrodes; and a touch controller electrically connected to the plurality of first electrodes and the plurality of second electrodes to control the touch sensor. Here, the second electrode includes a pair of electrode parts, one of the pair of electrode parts is disposed adjacent to at least one of the electrodes among the plurality of first electrodes, and the other of the pair of electrode parts is disposed adjacent to at least one of remaining electrodes among the plurality of first electrodes. The touch controller controls to apply at least one driving signal to the plurality of second electrodes and receive sensing signals from the plurality of first electrodes. The touch controller comprises a driving circuit unit electrically connected to the plurality of second electrodes. The driving circuit unit comprises a first switch element configured to electrically connect or open the pair of electrode parts of each of the second electrodes. The driving circuit unit comprises: a second switch element connected to one end of the first switch element; a third switch element connected to the other end of the first switch element; a fourth switch element connected between the second switch element and an AC ground; and a fifth switch element connected between the third switch element and the AC ground.
A touch input device including a display panel according to another embodiment of the present invention includes: a touch sensor including a plurality of first electrodes and a plurality of second electrodes disposed to cross the plurality of first electrodes; and a touch controller electrically connected to the plurality of first electrodes and the plurality of second electrodes to control the touch sensor. Here, the second electrode includes a pair of electrode parts, one of the pair of electrode parts is disposed adjacent to at least one of the electrodes among the plurality of first electrodes, and the other of the pair of electrode parts is disposed adjacent to at least one of remaining electrodes among the plurality of first electrodes. The touch controller controls to apply at least one driving signal to the plurality of second electrodes and receive sensing signals from the plurality of first electrodes. The touch controller comprises a driving circuit unit electrically connected to the plurality of second electrodes. The driving circuit unit comprises: a plurality of switching units electrically connected to the pair of electrode parts of the second electrode to electrically connect or open the pair of electrode parts to each other; a multiplexer configured to output two signals selected from among signals output from the plurality of switching units; and a differential amplifier configured to differentially amplify the two signals output from the multiplexer and output the differentially amplified signals.

The display noise caused by the driving of the display panel may be minimized by using the touch input device according to the embodiment of the present invention.

In addition, according to the present invention, the effect of the flicker which occurs on the display panel by the driving of the touch sensor may be minimized.

In addition, according to the present invention, the touch malfunction in the LGM state may be improved.

### BRIEF DESCRIPTION OF THE FIGURES

FIG. 1 is a schematic diagram showing a conventional laminated structure of the OCTA technology.
FIG. 2 is a schematic diagram showing a touch input device according to an embodiment of the present invention.
FIG. 3 is a schematic diagram showing a receiving circuit unit 110 according to an embodiment of a touch controller 15 shown in FIG. 2.
FIG. 4 is a schematic diagram showing a receiving circuit unit 110' according to another embodiment of the touch controller 15 shown in FIG. 2.
FIG. 5 is a schematic diagram showing a receiving circuit unit 110" according to another embodiment of the touch controller 15 shown in FIG. 2.
FIGS. 6A and 6B are views showing receiving circuit units 110‴ and 110ʺʺ according to another embodiment of the touch controller 15 shown in FIG. 2.
FIG. 7 is a schematic diagram showing a receiving circuit unit 110‴ʺ according to another embodiment of the touch controller 15 shown in FIG. 2.
FIG. 8 is a plan view showing a portion of an embodiment of a touch sensor 10 shown in FIG. 2.
FIGS. 9A and 9B are plan views in which the touch sensor shown in FIG. 8 is separated by layers.
FIG. 10 is a view for explaining electrical connection of a plurality of receiving electrodes shown in FIG. 8.
FIG. 11 is a plan view of a portion of another embodiment of the touch sensor 10 shown in FIG. 2.
FIGS. 12A and 12B are plan views in which the touch sensor shown in FIG. 11 is separated by layers.
FIG. 13 is a view for explaining electrical connection of a plurality of receiving electrodes shown in FIG. 11.
FIG. 14 is a plan view of a portion of another embodiment of the touch sensor 10 shown in FIG. 2.
FIGS. 15A and 15B are plan views in which the touch sensor shown in FIG. 14 is separated by layers.
FIG. 16 is a plan view of a portion of another embodiment of the touch sensor 10 shown in FIG. 2.
FIGS. 17A and 17B are plan views in which the touch sensor is shown in FIG. 16 is separated by layers.
FIG. 18 is a plan view of a portion of another embodiment of the touch sensor 10 shown in FIG. 2.
FIG. 19 is a schematic diagram of a touch input device according to another embodiment of the present invention.
FIG. 20A is a graph showing a multi-driving which is performed for each of four driving electrodes of the touch input device in FIG. 2. FIG. 20B is a table showing an example of a driving signal (or a driving code) that is simultaneously applied to four driving electrodes Tx0, Tx1, Tx2, and Tx3 during the multi-driving in FIG. 20A.
FIG. 21A is a graph showing the multi-driving of all driving electrodes in the touch input device shown in FIG. 19. FIG. 21B is a table showing an example of a driving signal (or driving code) applied to all driving electrodes Tx0, Tx1, Tx2, Tx3... simultaneously driven during the multi-driving in FIG. 21A.
FIGS. 22A and 22B are views for explaining a driving circuit unit 130' according to an embodiment of the touch controller 15 shown in FIG. 8.
FIG. 23 is a view for explaining a driving circuit unit 130‴ according to another embodiment of the touch controller 15 shown in FIG. 8.
FIG. 24 is a view for explaining a driving circuit unit 130ʺʺ according to another embodiment of the touch controller 15 shown in FIG. 8.
FIG. 25 is a view for explaining a driving circuit unit 130‴ʺ according to another embodiment of the touch controller 15 shown in FIG. 19.
FIG. 26 is a plan view of a portion of an embodiment of a touch sensor 10' shown in FIG. 19.
FIG. 27 is a plan view of a portion of another embodiment of the touch sensor 10' shown in FIG. 19.
FIG. 28 is a plan view of a portion of another embodiment of the touch sensor 10' shown in FIG. 19.
FIG. 29 is a plan view of a portion of another embodiment of the touch sensor 10' shown in FIG. 19.
FIG. 30 is a plan view of a portion of another embodiment of the touch sensor 10' shown in FIG. 19.
FIG. 31 is a view for explaining a first driving method of touch input devices 1 and 1' shown in FIGS. 2 and 19.
FIG. 32 is a view for explaining a second driving method of the touch input devices 1 and 1' shown in FIGS. 2 and 19.
FIG. 33 is a view for explaining a third driving method of the touch input devices 1 and 1' shown in FIGS 2 and 19.
FIG. 34 is a view for explaining a fourth driving method of the touch input devices 1 and 1' shown in FIGS. 2 and 19.
FIG. 35 is a view for explaining a fifth driving method of the touch input devices 1 and 1' shown in FIGS. 2 and 19.

### DETAILED DESCRIPTION

A touch input device according to various embodiments of the present document is an electronic device including at least one, for example, a smartphone, a tablet personal computer, a vehicle display device, a mobile phone, a video phone, an e-book reader, a laptop personal computer (laptop PC), a netbook computer, a mobile medical device, a camera, and a wearable device. Here, the wearable device is an accessory type (e.g. watch, ring, bracelet, anklet, necklace, glasses, contact lens, and head-mounted-device (HMD)), textile and clothing integral type (e.g. electronic clothing), a body attachment type (e.g. a skin pad or tattoo), and a living body implantation type (e.g. an implantable circuit).

FIG. 2 is a schematic diagram showing a touch input device according to an embodiment of the present invention.

Referring to FIG. 2, a touch input device 1 according to an embodiment of the present invention may include a touch sensor 10, a display panel 20, a touch controller 15 for controlling the touch sensor 10, and a display controller 20 for controlling the display panel 20. Here, the touch controller 15 and the display controller 20 may be integrated into one controller.

The touch sensor 10 includes a plurality of electrodes (or patterns). The plurality of electrodes includes a plurality of first electrodes and a plurality of second electrodes.

The touch controller 15 may include a driving unit 12, a detection unit 11, and a control unit 13.

The driving unit 12 applies a driving signal (or TX signal) to the touch sensor 10 by control of the controller 13. The detection unit 11 receives a sensing signal (or RX signal) from the touch sensor 10.

The driving unit 12 may sequentially supply driving signals to a plurality of driving electrodes of the touch sensor 10.

The detection unit 11 receives a signal output from a plurality of receiving electrodes of the touch sensor 10. Here, the signal may include information on capacitance variation between a driving electrode and a receiving electrode adjacent to each other, an LGM noise signal, and a display noise signal.

The detection unit 11 outputs a subtracted signal obtained by subtracting two signals from among the signals output from the plurality of receiving electrodes. The detection unit 11 may output the subtracted signal by converting analog to digital. The detection unit 11 may include a comparator and an ADC.

The control unit 13 may detect a touch and/or a touch position based on the digital signal output from the detection unit 11.

In FIG. 2, the detection unit 11, the driving unit 12, and the control unit 13 are shown separately for convenience of description. However, the embodiment of the present invention is not limited thereto. For example, at least one unit or two units of the detection unit 11, the driving unit 12, and the control unit 13 may be implemented as a single unit such as a module, a unit, a chip, or a circuit. In addition, all of the detection unit 11, the driving unit 12, and the control unit 13 may be implemented as one module, unit, chip, or circuit.

Like the OCTA method shown in FIG. 1, the touch sensor 10 may be disposed on the cell of the display panel 20 or may be disposed within the cell of the display panel 20 like the in-cell method. In some cases, the touch sensor 10 may be disposed below the display panel 20. For example, the touch sensor 10 may be formed directly on an upper substrate of the display panel 20 and/or an outer surface of a lower substrate (e.g., a top surface of the upper substrate or a bottom surface of the lower substrate) or the touch sensor 10 may be formed directly in an inner surface (e.g., a bottom surface of the upper substrate or a top surface of the lower substrate). The touch sensor 10 coupled to the display panel 20 is configured to a touch screen panel (TSP) or a touch display.

A plurality of scan lines (or gate lines) and a plurality of data lines may be disposed on the display panel 20. A subpixel may be disposed in an area in which the scan line and the data line intersect.

The display panel 20 may include an active area on which a plurality of subpixels are disposed and an inactive area disposed outside the active area. The active area may include the display screen of the touch input device. The display screen may have a rectangular shape in which a vertical length is longer than a horizontal length.

To control the display panel 20, the display controller 25 may include a gate driving circuit for driving various signal lines disposed on the display panel 20, a data driving circuit, and a display controller.

The gate driving circuit, controlled by a display controller, may control the driving timing of a plurality of subpixels by sequentially outputting display scan signals to a plurality of scan lines disposed on a display panel.

The data driving circuit may receive image data from the display controller and convert the image data into an analog-type data voltage. The data-driving circuit may control each subpixel to express brightness based on image data by outputting the data voltage (Vdata) to each data line according to the timing that the scan signal is applied to the scan line.

The display controller may supply various control signals to the gate driving circuit and the data driving circuit. The display controller controls operations of the gate driving circuit and the data driving circuit.

The touch sensor 10 includes a plurality of driving electrodes Tx0, Tx1, Tx2 ... and a plurality of receiving electrodes Rx0, Rx1, Rx2, Rx3 ....

The plurality of driving electrodes Tx0, Tx1, Tx2... and the plurality of receiving electrodes Rx0, Rx1, Rx2, Rx3... may be arranged to intersect each other. In particular, a mutual capacitance may be formed at their intersection between the plurality of driving electrodes Tx0, Tx1, Tx2... and the plurality of receiving electrodes Rx0, Rx1, Rx2, Rx3... at their intersections. The capacitance may be changed by an object in contact with or in proximity to the surface of the touch input device.

Each of the driving electrodes Tx0, Tx1, Tx2... extends in a first direction, and each receiving electrode Rx0, Rx1, Rx2, Rx3... extends in a second direction different from the first direction. Here, the second direction may be a direction perpendicular to the first direction.

Each of the plurality of receiving electrodes Rx0, Rx1, Rx2, Rx3... includes a pair of receiving electrode portions Rx0a and Rx0b, Rx1a and Rx1b, Rx2a and Rx2b, Rx3a and Rx3b... The pair of receiving electrode portions Rx0a and Rx0b, Rx1a and Rx1b, Rx2a and Rx2b, Rx3a and Rx3b... include a first receiving electrode portion Rx0a, Rx1a, Rx2a, Rx3a... and a second receiving electrode portion Rx0b, Rx1b, Rx2b, Rx3b....

The first receiving electrode portions Rx0a, Rx1a, Rx2a, Rx3a... among the plurality of receiving electrodes Rx0, Rx1, Rx2, Rx3... may be arranged to form mutual capacitance (cm) with a portion of driving electrodes Tx0, Tx2, Tx4, Tx6... among the plurality of driving electrodes Tx0, Tx1, Tx2.... The second receiving electrode portions Rx0b, Rx1b, Rx2b, Rx3b... among the plurality of receiving electrodes Rx0, Rx1, Rx2... may be arranged to form mutual capacitance with the remaining portion of driving electrodes Tx1, Tx3, Tx5, Tx7... among the plurality of driving electrodes Tx0, Tx1, Tx2...

The first receiving electrode portions Rx0a, Rx1a, Rx2a, Rx3a... among the plurality of receiving electrodes Rx0, Rx1, Rx2, Rx3... may be disposed immediately adjacent to the remaining portions of driving electrodes Tx0, Tx2, Tx4, Tx6... among the plurality of driving electrodes Tx0, Tx1, Tx2... Further the first receiving electrode portions Rx0a, Rx1a, Rx2a, Rx3a may be disposed not to be immediately adjacent to but spaced apart by a predetermined distance from the remaining portion of driving electrodes Tx1, Tx3, Tx5, Tx7... Here, at least one different electrode may be disposed between the first receiving electrode portions Rx0a, Rx1a, Rx2a, Rx3a... and the remaining portion of driving electrodes Tx1, Tx3, Tx5, Tx7... The different electrodes may be a portion of driving electrodes Tx0, Tx2, Tx4, Tx6...

The second receiving electrode portions Rx0b, Rx1b, Rx2b, Rx3b... among the plurality of receiving electrodes Rx0, Rx1, Rx2... may be disposed to be immediately adjacent to the remaining portion of driving electrodes Tx1, Tx3, Tx5, Tx7... among the plurality of driving electrodes Tx0, Tx1, Tx2... and the second receiving electrode portions Rx0b, Rx1b, Rx2b, Rx3b... may be disposed not to be immediately adjacent to but spaced a predetermined distance from a portion of driving electrodes Tx0, Tx2, Tx4, Tx6... among the plurality of driving electrodes Tx0, Tx1, Tx2.... Here, at least one different electrode may be disposed between the second receiving electrode portions Rx0b, Rx1b, Rx2b, Rx3b... and a portion of driving electrodes Tx0, Tx2, Tx4, Tx6... The different electrodes may be the remaining portion of driving electrodes Tx1, Tx3, Tx5, Tx7...

When a driving signal is applied to a portion of driving electrodes Tx0, Tx2, Tx4, Tx6..., a first signal is output from a first receiving electrode portion Rx0a, Rx1a, Rx2a, Rx3a... which forms mutual capacitance and a second signal is output from a second receiving electrode portions Rx0b, Rx1b, Rx2b, Rx3b... which do not substantially form mutual capacitance. The touch controller 15 may output a third signal by subtracting or differentially amplifying the second signal from the first signal and the touch controller 15 may detect a touch position of an object based on the third signal. Here, the first signal includes information on an amount of change in mutual capacitance caused by the object, a display noise (e.g., Zebra noise), an amount of image change, an LGM noise in a floating state, and the noise of Cathode re-transmission and the like. The cathode re-transmission phenomenon is a phenomenon in which, as a magnitude of resistance (RELVSS) of the ELVSS layer increases (i.e., as GND becomes weaker), a signal having a high frequency is also transmitted to the RX sensor and added to a main signal. On the other hand, the second signal contains almost no information on the amount of change in mutual capacitance caused by the object but includes the remaining noise information. The remaining noise information may include display noise (e.g., Zebra noise), an amount of change according to image change, an LGM noise in a floating state, noise due to a cathode re-transmission phenomenon, and the like. Therefore, since the detection unit 11 subtracts the second signal from the first signal, noise information does not exist in the signal input to the controller 13. However, only information on the amount of change in mutual capacitance caused by the object may be included.

Conversely, when a driving signal is applied to the remaining portion of driving electrodes Tx1, Tx3, Tx5, Tx7..., a second signal is output from the second receiving electrode portions Rx0b, Rx1b, Rx2b, Rx3b..., which form mutual capacitance, and a first signal is output from the first receiving electrode portions Rx0a, Rx1a, Rx2a, Rx3a... which do not substantially form mutual capacitance therewith. The touch controller 15 may subtract or differentially amplify the first signal from the second signal to output a third signal and the touch controller 15 may detect the touch position of the object based on the third signal. Here, since the second signal includes information on the amount of change in mutual capacitance caused by the object, noise information does not exist in the third signal obtained by subtracting the first signal from the second signal, and only information on the amount of change in mutual capacitance caused by the object is included in the third signal.

The plurality of driving electrodes Tx0, Tx1, Tx2... and the plurality of receiving electrodes Rx0, Rx1, Rx2... may be disposed together on the same layer (1 layer) or in different double layers (2 layers), respectively. In addition, some of the plurality of driving electrodes Tx0, Tx1, Tx2... may be disposed on a different layer from the other driving electrodes. Some of the plurality of receiving electrodes Rx0, Rx1, Rx2... may also be disposed on a different layer from the other receiving electrodes. The plurality of driving electrodes Tx0, Tx1, Tx2... and the plurality of receiving electrodes Rx0, Rx1, Rx2... may have a diamond pattern, a circular shape, an elliptical shape, or a polygonal shape.

The plurality of driving electrodes Tx0, Tx1, Tx2... and a plurality of receiving electrodes Rx0, Rx1, Rx2... may be composed of a metal mesh and patterned on a thin film encapsulation (TFE) layer within the display panel 20.

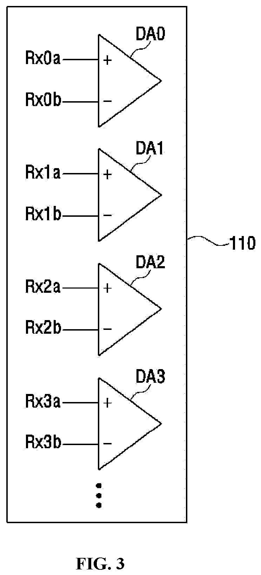

FIG. 3 is a schematic diagram showing a receiving circuit unit 110 according to an embodiment of a touch controller 15 shown in FIG. 2.

Referring to FIG. 3, the receiving circuit unit 110 is electrically connected to the plurality of receiving electrodes Rx0, Rx1, Rx2, Rx3... of the touch sensor 10 shown in FIG. 2.

Each of the plurality of receiving electrodes Rx0, Rx1, Rx2, Rx3... of the touch sensor 10 shown in FIG. 2 includes a pair of receiving electrode portions Rx0a and Rx0b, Rx1a and Rx1b, Rx2a and Rx2b, Rx3a and Rx3b....

The receiving circuit unit 110 may include a plurality of differential amplifiers DA0, DA1, DA2, DA3... Each of the differential amplifiers DA0, DA1, DA2, DA3... includes a pair of inputs. Each of the differential amplifiers DA0, DA1, DA2, DA3... may differentially amplify and output the two signals received through the pair of input terminals.

The pair of input terminals corresponds to a pair of receiving electrode portions Rx0a and Rx0b, Rx1a and Rx1b, Rx2a and Rx2b, Rx3a and Rx3b of each of receiving electrodes Rx0, Rx1, Rx2, Rx3... of the touch sensor 10. For example, the pair of input terminals of the Oth differential amplifier DA0 is electrically connected to the pair of receiving electrode portions Rx0a and Rx0b of the Oth receiving electrode Rx0, respectively. In this way, the remaining differential amplifiers DA1, DA2, DA3... are electrically connected to the remaining receiving electrodes Rx1, Rx2, Rx3...

A signal output to an output terminal of each of the differential amplifiers DA0, DA1, DA2, DA3... may be a differential signal or a single signal.

The receiving circuit unit 110 may be included in the detection unit 11 shown in FIG. 2.

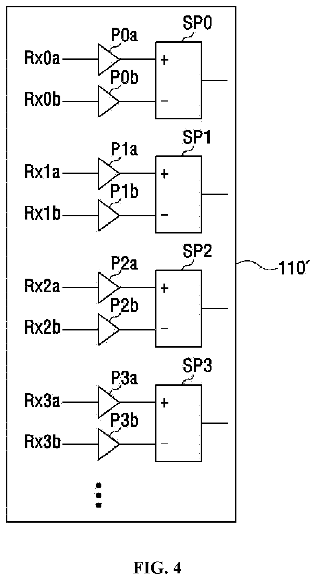

FIG. 4 is a schematic diagram showing a receiving circuit unit 110' according to another embodiment of the touch controller 15 shown in FIG. 2.

Referring to FIG. 4, the receiving circuit unit 110' is electrically connected to the plurality of receiving electrodes Rx0, Rx1, Rx2, Rx3 ... of the touch sensor 10 shown in FIG. 2.

The receiving circuit unit 110' includes a plurality of amplifiers P0a, P0b, P1a, P1b, P2a, P2b, P3a, P3b... and a plurality of signal processors SP0, SP1, SP2, SP3...

Each of a pair of receiving electrode portions Rx0a and Rx0b, Rx1a and Rx1b, Rx2a and Rx2b, Rx3a and Rx3b... of each of the receiving electrodes Rx0, Rx1, Rx2, Rx3... of the touch sensor 10 is electrically connected to the input terminal of a pair of amplifiers P0a and P0b, P1a and P1b, P2a and P2b, P3a and P3b....

Each of signal processors SP0, SP1, SP2, SP3 ... is electrically connected to the output terminals of the pair of amplifiers P0a and P0b, P1a and P1b, P2a and P2b, P3a and P3b .... One of the pair of amplifiers P0a and P0b, P1a and P1b, P2a and P2b, P3a and P3b... may be connected to positive (+) input terminals of the signal processors SP0, SP1, SP2, SP3 ..., and the other amplifiers P0b, P1b, P2b, P3b ... may be connected to negative (-) input terminals of the signal processors SP0, SP1, SP2, SP3 ....

The receiving circuit unit 110' shown in FIG. 4, after receiving a signal from the pair of receiving electrode portions Rx0a and Rx0b, Rx1a and Rx1b, Rx2a and Rx2b, Rx3a and Rx3b of each of receiving electrodes Rx0, Rx1, Rx2, Rx3... Rx3b... through the input terminal as a single-ended input, a differential operation may be performed by an amplifier and a signal processing unit.

On the other hand, an analog signal from the pair of receiving electrodes Rx0a and Rx0b, Rx1a and Rx1b, Rx2a and Rx2b, Rx3a, and Rx3b ... of the receiving circuit unit 110' shown in FIG. 4 may be converted into a digital signal, and then performed in a digital block.

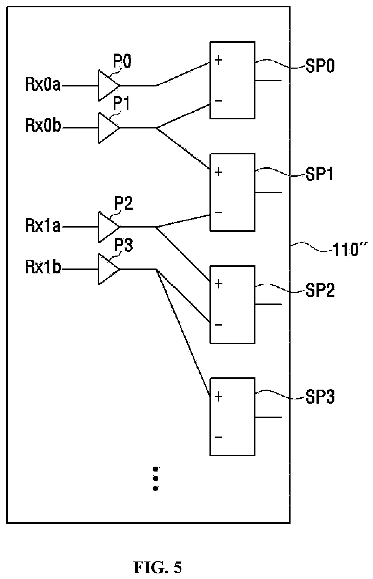

FIG. 5 is a schematic diagram showing a receiving circuit unit 110" according to another embodiment of the touch controller 15 shown in FIG. 2.

Referring to FIG. 5, the receiving circuit unit 110 " is electrically connected to the plurality of receiving electrodes Rx0, Rx1, Rx2, Rx3 ... of the touch sensor 10 shown in FIG. 2.

The receiving circuit unit 110" includes a plurality of amplifiers P0, P1, P2, P3... and a plurality of signal processors SP0, SP1, SP2, SP3....

The receiving electrode portions Rx0a, Rx0b, Rx1a, Rx1b... of the plurality of receiving electrodes Rx0, Rx1, Rx2, Rx3... of the touch sensor 10 are electrically connected to the input terminals of the plurality of amplifiers P0, P1, P2, P3... in a one-to-one corresponding manner. For example, the Oth amplifier P0 is connected to the first receiving electrode portion Rx0a of the Oth receiving electrode Rx0. The first amplifier P1 is connected to the second receiving electrode portion Rx0b of the Oth receiving electrode Rx0. The second amplifier P2 is connected to the first receiving electrode portion Rx1a of the first receiving electrode Rx1. The third amplifier P3 is connected to the second receiving electrode portion Rx1b of the first receiving electrode Rx1. In this way, other receiving electrode portions are electrically connected to the plurality of amplifiers.

Output terminals of the plurality of amplifiers P0, P1, P2, P3... are electrically connected to the plurality of signal processors SP0, SP1, SP2, SP3... Here, the remaining amplifiers are electrically connected to two signal processors, respectively, except the Oth amplifier P0, which is a first amplifier, and a last amplifier. Meanwhile, although not shown in separate drawings, the Oth amplifier P0, which is the first of the amplifier, and the last amplifier may be electrically connected to a separate signal processor. The separated signal processor may output a difference between an output signal of the Oth amplifier P0 and an output signal of the last amplifier.

Each of signal processors SP0, SP1, SP2, SP3... is electrically connected to the output terminals of two amplifiers among the plurality of amplifiers P0, P1, P2, P3... In other words, each of the signal processors SP0, SP1, SP2, SP3... may be configured to receive a differential signal between the receiving electrode portions. For example, the output terminal of the Oth amplifier P0 may be connected to the positive (+) terminal of the Oth signal processor SP0. The output terminal of the first amplifier P1 may be connected to the negative (-) terminal of the Oth signal processor SP1. The output terminal of the first amplifier P1 may be connected to the positive (+) terminal of the first signal processor SP1. The output terminal of the second amplifier P2 may be connected to the negative (-) terminal of the first signal processor SP1. The output terminal of the second amplifier P2 may be connected to the positive (+) terminal of the second signal processor SP2. The output terminal of the third amplifier P3 may be connected to the negative (-) terminal of the second signal processor SP2. The output terminal of the third amplifier P3 may be connected to the positive (+) terminal of the third signal processor SP3. The output terminal of the fourth amplifier (not shown) may be connected to a negative (-) terminal of the third signal processor SP3. Repetitively in this way, the remaining amplifiers that are not shown in the drawing may be electrically connected to the signal processors.

According to the receiving circuit unit 110 " shown in FIG. 5, it is possible to prevent erroneous touch operation in a special situation in which water is disposed on the touch sensor 10 or a metal object such as a coin is disposed on the touch sensor 10 shown in FIG. 2.

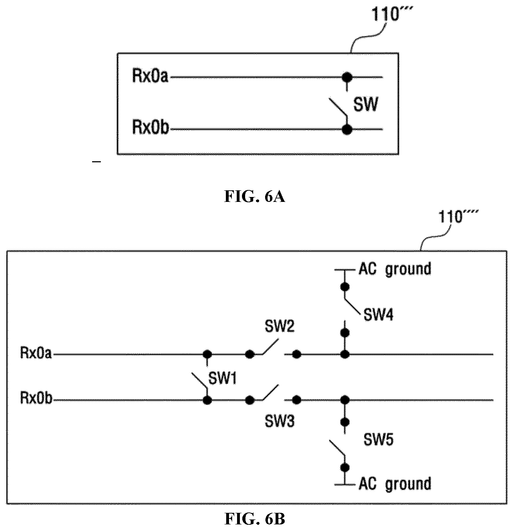

FIGS. 6A and 6B are views showing receiving circuit units 110‴ and 110ʺʺ according to another embodiment of the touch controller 15 shown in FIG. 2.

Referring to FIG. 6A, the receiving circuit unit 110‴ includes a switch element SW for electrically shorting or opening a pair of receiving electrode portions Rx0a and Rx0b of each receiving electrode Rx0. The switch element SW is controlled by a control unit (not shown). When the switch element SW is closed, a pair of receiving electrode portions Rx0a and Rx0b of each receiving electrode Rx0 are electrically connected. Meanwhile, although not shown, a switch element may be disposed between a pair of receiving electrode portions of another receiving electrode.

In the receiving circuit unit 110‴, the switch element SW may be controlled to connect electrically the pair of receiving electrode portions Rx0a and Rx0b. This control method may be used when driving the touch sensor 10 shown in FIG. 2 to a self-sensing mode or a stylus sensing mode for sensing a pen signal from a stylus.

Methods for driving the touch sensor 10 include self-sensing and mutual-sensing. The self-sensing is a method of recognizing whether or not an object is touched and/or a touch position from a change in capacitance of each electrode itself by applying a driving signal to each electrode and receiving a sensing signal from the corresponding electrode at the same time. On the other hand, the mutual-sensing is a method of detecting a change of mutual capacitance between a driving electrode and a receiving electrode by an object. The touch controller 15 controls the touch sensor 10 to detect whether or not an object is touched and/or a position of a touch by using any one of the above two methods, or by using both methods. Here, when both methods are used, the touch controller 15 may control each of the two methods to operate independently using time division.

Referring to FIG. 6B, the receiving circuit unit 110ʺʺ includes a plurality of switch elements SW1, SW2, SW3, SW4, and SW5.

The first switch element SW1 performs the same role as the switch element SW shown in FIG. 6A. The first switch element SW1 is connected between the pair of receiving electrode portions Rx0a and Rx0b. The first switch element SW1 may be shorted or opened according to the control of a controller (not shown).

The second to fifth switch elements SW2, SW3, SW4, and SW5 may control to connect any of the receiving electrodes among the pair of receiving electrode portions Rx0a and Rx0b of each receiving electrode Rx0 to the input terminal of an amplifier (not shown).

The second switch element SW2 may be connected to one end of the first switch element SW1. The third switch element SW3 may be connected to the other end of the first switch element SW1.

The fourth switch element SW4 is connected between the output terminal of the second switch element SW2 and the AC ground. The fifth switch element SW5 is connected between the output terminal of the third switch element SW3 and the AC ground.

On the other hand, the second and fifth switch elements SW2 and SW5 or the third and fourth switch elements SW3 and SW4 may be omitted depending on whether any of the receiving electrode portions between the pair of receiving electrode portions Rx0a and Rx0b is connected to the input terminal of an amplifier (not shown).

The receiving circuit unit 110ʺʺ controls the first switch element SW1. The receiving circuit unit 110ʺʺ electrically connects the pair of receiving electrode portions Rx0a and Rx0b and controls the touch sensor 10 shown in FIG. 2 to be in the self-sensing mode or the stylus sensing mode. In addition, the receiving circuit unit 110ʺʺ controls the second to fifth switch elements SW2, SW3, SW4, and SW5 to connect any of the receiving electrode portions between the pair of receiving electrode portions Rx0a and Rx0b to another electronic device (e.g., an amplifier).

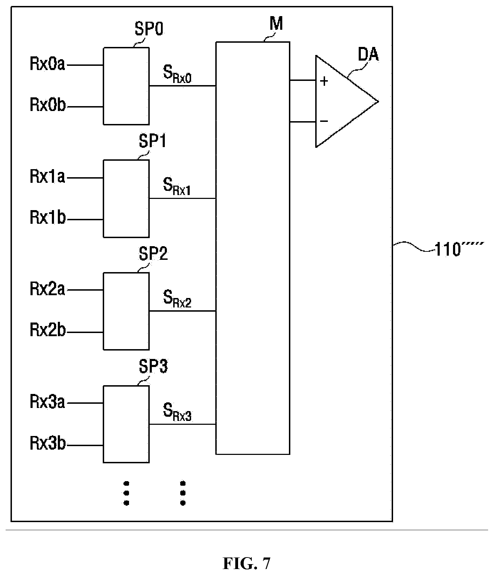

FIG. 7 is a schematic diagram showing a receiving circuit unit 110‴ʺ according to another embodiment of the touch controller 15 shown in FIG. 2.

Referring to FIG. 7, the receiving circuit unit 110‴ʺ may include a plurality of switching units SP0, SP1, SP2, SP3..., a multiplexer M, and a differential amplifier DA.

Each switching unit SP0, SP1, SP2, SP3... electrically connects or opens a pair of receiving electrode portions Rx0a and Rx0b... of each receiving electrode to each other according to a control signal. For example, a pair of input terminals of the Oth switching unit SP0 is electrically connected to a pair of receiving electrode portions Rx0a and Rx0b of the Oth receiving electrode, and one output terminal is connected to one input terminal among a plurality of input terminals of the multiplexer M. The other switching units SP1, SP2, SP3... are connected in the same manner.

The multiplexer M includes a plurality of input terminals connected with the output terminals of the plurality of switching units SP0, SP1, SP2, SP3, ... in a one-to-one corresponding manner, and further includes at least two output terminals. The two output terminals are respectively connected to the two input terminals of the differential amplifier DA.

The receiving circuit unit 110‴ʺ may remove a display noise caused by driving the display panel 20 shown in FIG. 2. Specifically, when the touch sensor 10 shown in FIG. 2 drives in the pen sensing mode for sensing the pen signal from a stylus, the receiving circuit unit 110‴ʺ electrically connects the plurality of switching units SP0, SP1, SP2, SP3... to the pair of receiving electrode portions Rx0a and Rx0b, Rx1a and Rx1b, Rx2a and Rx2b, Rx3a and Rx3b. The receiving circuit unit 110‴ʺ controls the multiplexer M to output two signals to the differential amplifier DA among a plurality of signals S_{Rx0,} S_{Rx1,} S_{Rx2,} S_{Rx3...} of a plurality of switching units SP0, SP1, SP2, SP3 .... The receiving circuit unit 110‴ʺ may differentially amplify the two signals selected by the multiplexer M. The differentially amplified signal includes the mostly removed display noise of the display panel 20, and the receiving circuit unit 110‴ʺ prevents a touch malfunction and improves touch sensitivity.

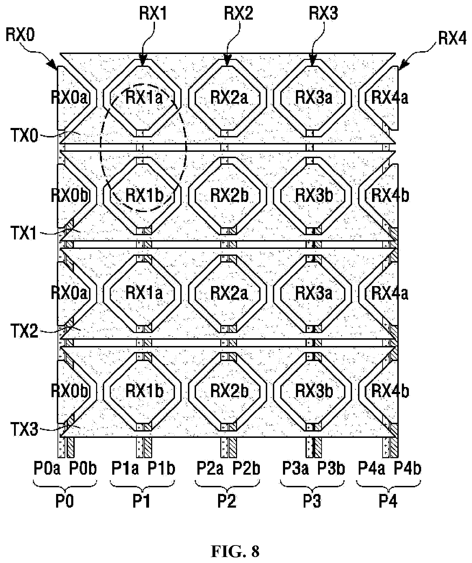

FIG. 8 to 17 are schematic diagrams for showing various embodiments of the touch sensor 10 shown in FIG. 2.

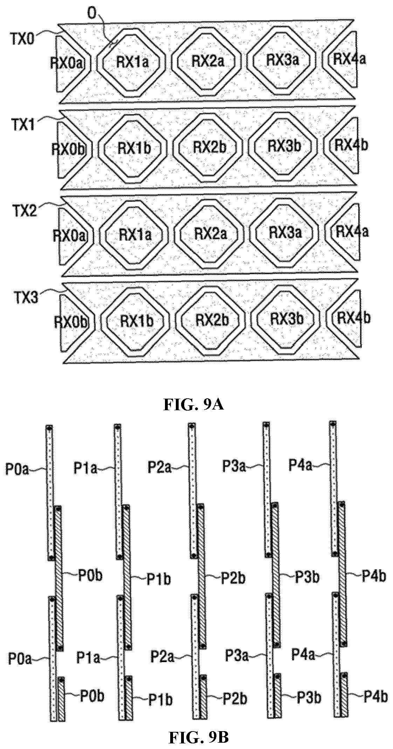

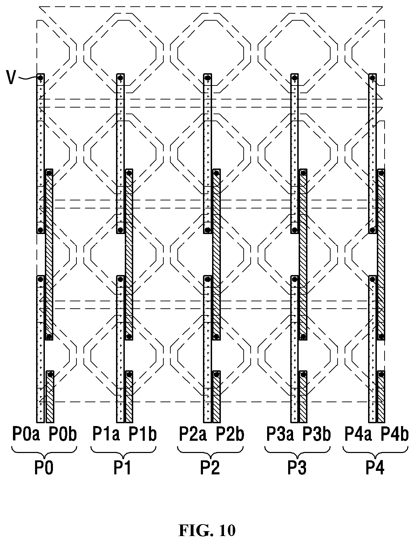

FIG. 8 is a plan view showing a portion of an embodiment of a touch sensor 10 shown in FIG. 2. FIGS. 9A and 9B are plan views in which the touch sensor shown in FIG. 8 is separated by layers. FIG. 10 is a view for explaining electrical connection of a plurality of receiving electrodes shown in FIG. 8.

Referring to FIGS. 8 to 10, a touch sensor according to an embodiment of the present invention may be disposed on a display panel or inside the display panel.

The touch sensor according to an embodiment of the present invention includes a plurality of first electrodes and a plurality of second electrodes. Among the plurality of first electrodes and the plurality of second electrodes, the electrodes to which the driving signal is applied may be driving electrodes, and the remaining electrodes may be receiving electrodes. Hereinafter, the plurality of first electrodes may be a plurality of driving electrodes TX0, TX1, TX2, TX3..., and the plurality of second electrodes may be a plurality of receiving electrodes RX0, RX1, RX2, RX3, RX4....

The plurality of driving electrodes TX0, TX1, TX2, TX3... may include a Oth driving electrode TX0, a first driving electrode TX1, a second driving electrode TX2, and a third driving electrode TX3. Here, the plurality of driving electrodes TX0, TX1, TX2, TX3 ... correspond to the plurality of driving electrodes Tx0, Tx1, Tx2... shown in FIG. 2.

The plurality of receiving electrodes RX0, RX1, RX2, RX3, RX4... may include a Oth receiving electrode RX0, a first receiving electrode RX1, a second receiving electrode RX2, a third receiving electrode Rx3, and a fourth receiving electrode Rx4. Here, the plurality of receiving electrodes RX0, RX1, RX2, RX3, RX 4... correspond to the plurality of receiving electrodes Rx0, Rx1, Rx2, Rx3, Rx4... shown in FIG. 2.

The plurality of driving electrodes TX0, TX1, TX2, TX3 ... are arranged along the second direction (or vertical direction). Each of the plurality of driving electrodes TX0, TX1, TX2, TX3 ... extends in the first direction (or horizontal direction) perpendicular to the second direction. The plurality of receiving electrodes RX0, RX1, RX2, RX3, RX4... may be arranged along the second direction. Conversely, the plurality of driving electrodes TX0, TX1, TX2, TX3... are arranged along the first direction (or horizontal direction), and the plurality of receiving electrodes RX0, RX1, RX2, RX3, RX4... may be arranged along the second direction (or vertical direction).

A capacitance may be formed between the plurality of driving electrodes TX0, TX1, TX2, TX3 ... and the plurality of receiving electrodes RX0, RX1, RX2, RX3, RX4 .... This capacitance changes when a touch input occurs at or around a corresponding point. Accordingly, it is possible to detect whether a touch occurs and a touch input by detecting the capacitance variation of a signal from the plurality of receiving electrodes RX0, RX1, RX2, RX3, RX4....

Each of the plurality of driving electrodes TX0, TX1, TX2, TX3... may have a shape of a rectangular pattern or a bar pattern extending in the first direction and have a plurality of openings O arranged along the first direction therein.

One receiving electrode may be disposed in each opening O. The shape of each opening O corresponds to a shape of one receiving electrode disposed therein. For example, as shown in FIG. 8, the rest of the plurality of openings O except the openings disposed at the left and right edges may have a lozenge shape. The openings disposed at the left and right edges may have a triangular shape among the plurality of openings O. Although not shown in the drawings, all of the openings O may each have a lozenge shape. Alternatively, the plurality of openings O may have various shapes such as a polygonal shape, a rectangular shape, a circular shape, or an elliptical shape.

Each receiving electrode Rx0, RX1, RX2, RX3, RX4, ... has a plurality of receiving electrode patterns Rx0a, RX0b, RX1a, RX1b, RX2a, RX2b, RX3a, RX3b, RX4a, RX4b and connection patterns P0, P1, P2, P3, P4. Here, some receiving electrode patterns RX0a, RX1a, RX2a, RX3a, RX4a among the plurality of receiving electrode patterns RX0a, RX0b, RX1a, RX1b, RX2a, RX2b, RX3a, RX3b, RX4a, RX4b corresponds to some receiving electrodes Rx0a, Rx1a, Rx2a, Rx3a, ... in FIG. 2. The remaining receiving electrode patterns RX0b, RX1b, RX2b, RX3b, RX4b correspond to the remaining receiving electrodes Rx0b, Rx1b, Rx2b, Rx3b, Rx4b ... in FIG. 2.

As shown in FIG. 9A, a plurality of driving electrodes TX0, TX1, TX2, TX3... and a plurality of receiving electrode patterns RX0a, RX0b, RX1a, RX1b, RX2a, RX2b, RX3a, RX3b, RX4a, RX4b may be disposed together on a first layer. Here, a plurality of driving electrodes Tx0, TX1, TX2, TX3... and a plurality of receiving electrode patterns Rx0a, RX0b, RX1a, RX1b, RX2a, RX2b, RX3a, RX3b RX4a, RX4b disposed on the first layer may be implemented as a metal mesh. As shown in FIG. 9B, the plurality of connection patterns P0a, P0b, P1a, P1b, P2a, P2b, P3a, P3b, P4a, and P4b may be disposed on a second layer. The second layer is different from the first layer in FIG. 9A and the second layer is electrically insulated from the first layer. Here, the plurality of connection patterns P0a, P0b, P1a, P1b, P2a, P2b, P3a, P3b, P4a, and P4b may be implemented as a metal mesh. The first layer of FIG. 9A may be disposed on the second layer in FIG. 9B, and vice versa.

A plurality of receiving electrode patterns of each receiving electrode may be divided into at least two groups. Each of the receiving electrode patterns of one group is alternately disposed between the receiving electrode patterns of the other group. The receiving electrode patterns in one group are electrically separated from the receiving electrode patterns in the other group. Here, the receiving electrode pattern in one group may be referred to as a first receiving electrode pattern, and the receiving electrode pattern in the other group may be referred to as a second receiving electrode pattern.

The plurality of connection patterns included in each receiving electrode include first connection patterns for electrically connecting first receiving electrode patterns in one group and second connection patterns for electrically connecting second receiving electrode patterns in the other group.

For example, the Oth receiving electrode RX0 may include a plurality of receiving electrode patterns RX0a and RX0b and a plurality of connection patterns P0. The plurality of receiving electrode patterns RX0a and RX0b may include a receiving electrode pattern RX0a of the first group and a receiving electrode pattern RX0b of the second group, the receiving electrode patterns RX0a of the first group, and the receiving electrode patterns RX0b of the second group are alternately arranged one by one along the second direction. The receiving electrode patterns RX0a of the first group and the receiving electrode patterns RX0b of the second group may be electrically separated from each other. The Oth connection patterns P0 include first connection patterns P0a for electrically connecting the first group of receiving electrode patterns RX0a and second connection patterns P0b for electrically connecting the receiving electrode patterns RX0b of the second group.

The first receiving electrode RX1 may include a plurality of receiving electrode patterns RX1a and RX1b, and a plurality of connection patterns P1. The plurality of receiving electrode patterns RX1a and RX1b may include a receiving electrode pattern RX0a of the first group and a receiving electrode pattern RX1b of the second group, the receiving electrode patterns RX1a of the first group, and the receiving electrode patterns RX1b of the second group are alternately arranged one by one along the second direction. The receiving electrode patterns RX1a of the first group and the receiving electrode patterns RX1b of the second group may be electrically separated from each other. The first connection patterns P1 include the first connection pattern P1a for electrically connecting the receiving electrode patterns RX1a of the first group and the second connection pattern P1b for electrically connecting the receiving electrode patterns RX1b of the second group.

The second receiving electrode RX2 may include a plurality of receiving electrode patterns RX2a and RX2b, and a plurality of connection patterns P2. The plurality of receiving electrode patterns RX2a and RX2b may include a receiving electrode pattern RX2a of the first group and a receiving electrode pattern RX2b of the second group, the receiving electrode patterns RX2a of the first group and the receiving electrode patterns RX2b of the second group are alternately arranged one by one along the second direction. The receiving electrode patterns RX2a of the first group and the receiving electrode patterns RX2b of the second group may be electrically separated from each other. The second connection patterns P2 include the first connection pattern P2a for electrically connecting the receiving electrode patterns RX2a of the first group and the second connection pattern P2b for electrically connecting the receiving electrode patterns RX2b of the second group.

The third receiving electrode RX3 may include a plurality of receiving electrode patterns RX3a and RX3b, and a plurality of connection patterns P3. The plurality of receiving electrode patterns RX3a and RX3b may include a receiving electrode pattern RX3a of the first group and a receiving electrode pattern RX3b of the second group, the receiving electrode patterns RX3a of the first group, and the receiving electrode patterns RX3b of the second group are alternately arranged one by one along the second direction. The receiving electrode patterns RX3a of the first group and the receiving electrode patterns RX3b of the second group may be electrically separated from each other. The third connection patterns P3 include the first connection pattern P3a for electrically connecting the receiving electrode patterns RX3a of the first group and the second connection pattern P3b electrically for connecting the receiving electrode patterns RX3b of the second group.

The fourth receiving electrode RX4 may include a plurality of receiving electrode patterns RX4a and RX4b and a plurality of connection patterns P4. The plurality of receiving electrode patterns RX4a and RX4b may include a receiving electrode pattern RX4a of the first group and a receiving electrode pattern RX4b of the second group, the receiving electrode patterns RX4a of the first group, and the receiving electrode patterns RX4b of the second group are alternately arranged one by one along the second direction. The receiving electrode patterns RX4a of the first group and the receiving electrode patterns RX4b of the second group may be electrically separated from each other. The fourth connection patterns P4 include the first connection pattern P4a for electrically connecting the receiving electrode patterns RX4a of the first group and the second connection pattern P4b for electrically connecting the receiving electrode patterns RX4b of the second group.

The plurality of receiving electrode patterns RX0a, RX0b, RX1a, RX1b, RX2a, RX2b, RX3a, RX3b, RX4a, and RX4b are disposed inside the plurality of openings O of the plurality of driving electrodes TX0, TX1, TX2, TX3.... One receiving electrode pattern is disposed inside one opening O. Each receiving electrode pattern has a shape corresponding to that of the corresponding opening.

In an arbitrary receiving electrode RX1, between the receiving electrode patterns RX1a of the first group and the receiving electrode patterns RX1b of the second group disposed adjacent to each other, a portion of the driving electrode TX0 immediately adjacent to a periphery of the receiving electrode patterns RX1a in the first group and a portion of the driving electrode TX1 immediately adjacent to the periphery of the receiving electrode pattern RX1b in the second group are disposed together.

An arbitrary driving electrode TX0 is disposed immediately adjacent to the periphery of the first group of receiving electrode patterns RX0a, RX1a, RX2a, RX3a, and RX4a. Another driving electrode TX1 is disposed immediately adjacent to the periphery of the second group of receiving electrode patterns RX0b, RX1b, RX2b, RX3b, and RX4b. Another driving electrode TX1 is disposed to be separated from the receiving electrode patterns RX0a, RX1a, RX2a, RX3a, and RX4a of the first group by the arbitrary driving electrode TX0.

Each connection pattern P0a, P0b, P1a, P1b, P2a, P2b, P3a, P3b, P4a, and P4b may have a bar pattern shape extending along the second direction. The connection patterns P0a, P0b, P1a, P1b, P2a, P2b, P3a, P3b, P4a, and P4b may include at least one conductive via v. The conductive vias v may be disposed at both ends of each connection pattern.

In the Oth receiving electrode RX0, each of the first connection patterns P0a connects electrically two adjacent receiving electrode patterns RX0a among the first group of receiving electrode patterns through the conductive via v. Each of the first connection patterns P0a is disposed to overlap under the second group of the receiving electrode patterns RX0. Each of the first connection patterns is disposed between the two adjacent receiving electrode patterns RX0a. Each of the second connection patterns P0b electrically connects two adjacent receiving electrode patterns RX0b of the second group of receiving electrode patterns RX0b through the conductive via v. Each of the second connection patterns P0b is disposed to overlap under the first group of the receiving electrode patterns RX0a disposed between the two adjacent receiving electrode patterns RX0b. The first connection patterns P1a, P2a, P3a, and P4a, and the second connection patterns P1b, P2b, P3b, and P4b of the remaining receiving electrodes RX1, RX2, RX3, and RX4 are also disposed in the same manner as described above.

Hereinafter, an operation will be described in detail when a driving signal is applied to at least one of the plurality of driving electrodes TX0, TX1, TX2, and TX3. For convenience of explanation, an operation of the first receiving electrode RX1 and an operation of the detection unit 11 of FIG. 2 will be described in detail.

When driving signals are sequentially or simultaneously applied to the plurality of driving electrodes TX0, TX1, TX2, TX3, two sensing signals are output from the first connection pattern P1. The first signal is a signal output from the first connection pattern P1a, and the second signal is a signal output from the second connection pattern P1b. Accordingly, the first and second signals of two channels are output for each of the receiving electrodes RX0, RX1, RX2, RX3, and RX4. The first and second signals are simultaneously output, and the first and second signals may be applied to the detection unit 11 of FIG. 2.

According to the driving electrodes TX0, TX1, TX2, TX3... to which the driving signal is applied, either the first signal or the second signal may be an active channel signal (or an active receiving signal ARX), and the other may be a dummy channel signal (or dummy receiving signal DRX). Specifically, when the driving signal is applied to the driving electrodes TX0 and/or TX2 of the first group of receiving electrode patterns RX1a, the first signal from the first connection pattern P1a is an active channel signal, and the second signal output from the second connection pattern P1b becomes a dummy channel signal. On the other hand, when a driving signal is applied to the driving electrodes TX1 or/and TX3 of the receiving electrode pattern RX1b of the second group, the second signal output from the second connection pattern P1b becomes an active channel signal, and the first signal output from the first connection pattern P1a becomes a dummy channel signal.

For example, as shown in FIG. 8, it is assumed that an object (dotted line) approaches or contacts an intersection point between the first driving electrode TX1 and the first receiving electrode RX1. When a driving signal is applied to the first driving electrode TX1, the capacitance (or mutual active capacitance) formed between the receiving electrode pattern RX1b belonging to the second group of the first receiving electrode RX1 and the first driving electrode TX1 may change. The second signal including the changed capacitance variation information is an active channel signal, and the second signal is output from the second connection pattern P1b.

Meanwhile, capacitance (or dummy capacitance) formed between the receiving electrode patterns RX1a belonging to the first group of the first receiving electrodes RX1 and the first driving electrode TX1 may also change. The first signal including capacitance variation information is a dummy channel signal output from the first connection pattern P1a.

The detection unit 11 shown in FIG. 2 subtracts the first signal output from the second signal. The first signal is output from the first connection pattern P1a, the second signal is output from the second connection pattern P1b. As a result, all or most of the cathode retransmission noise signal, the LGM noise signal, the display noise signal of the receiving electrode pattern RX1b of the second group, and the receiving electrode pattern RX1a of the first group may be canceled out.

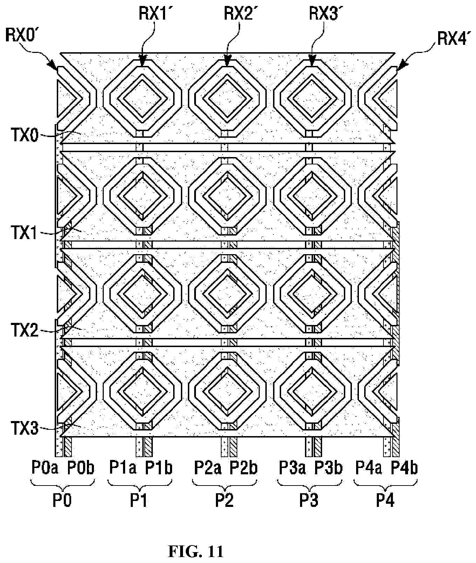

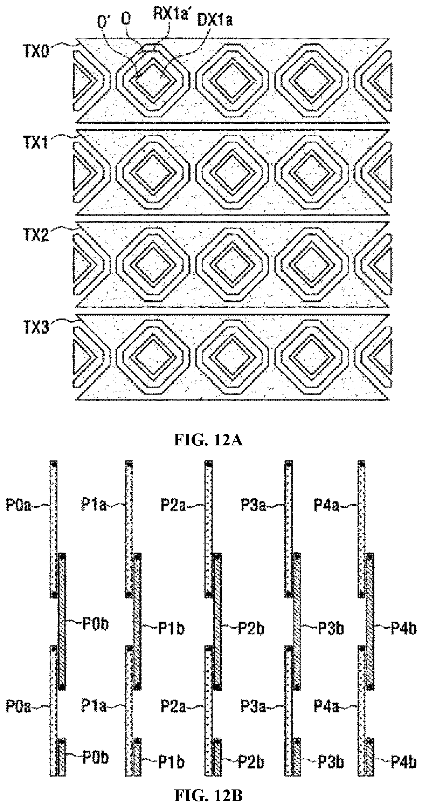

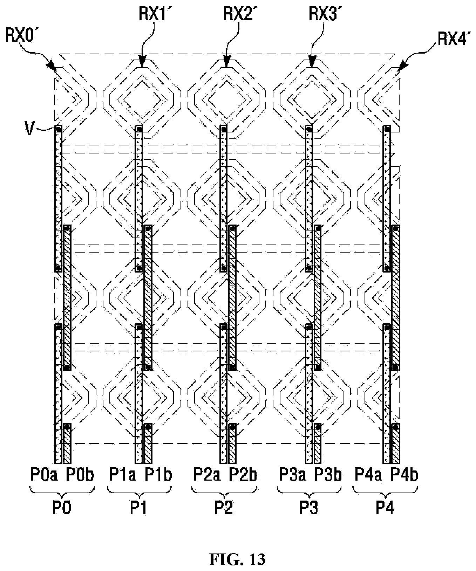

FIG. 11 is a plan view of a portion of another embodiment of the touch sensor 10 shown in FIG. 2. FIGS. 12A and 12B are plan views in which the touch sensor shown in FIG. 11 is separated by layers. FIG. 13 is a view for explaining electrical connection of a plurality of receiving electrodes shown in FIG. 11.

Compared to the touch sensor of the embodiments of FIGS. 8 to 10, a touch sensor according to another embodiment of the present invention shown in FIGS. 11 to 13 has a difference in a plurality of receiving electrodes Rx0', RX1', RX2', RX3', and RX4'. In particular, structures of the plurality of receiving electrode patterns RX1a' included in the respective receiving electrodes RX0', RX1', RX2', RX3', and RX4' are different. Hereinafter, the structures of the plurality of receiving electrode patterns RX1a' will be described in detail. Descriptions of remaining configurations will refer to the above descriptions.

The plurality of receiving electrode patterns RX1a' included in each of the receiving electrodes RX0', RX1', RX2', RX3', and RX4' have an opening O' therein, and a dummy pattern DX1a is disposed inside the opening O'. Here, the dummy pattern DX1a may have a shape corresponding to that of the opening O'.

The dummy pattern DX1a is not electrically connected to the connection patterns P0a, P0b, P1a, P1b, P2a, P2b, P3a, P3b, P4a, and P4b. The dummy pattern DX1a remains electrically floating.

An operation of the touch sensor according to another embodiment of the present invention shown in FIGS. 11 to 13 is the same as that of the touch sensor according to an embodiment of the present invention shown in FIGS. 8 to 10. Therefore, the touch input device including the touch sensor according to another embodiment of the present invention shown in FIGS. 11 to 13 also has an advantage of being able to remove various noises occurring at touch sensing, e.g., the cathode retransmission noise signal, the display noise, and the LGM noise.

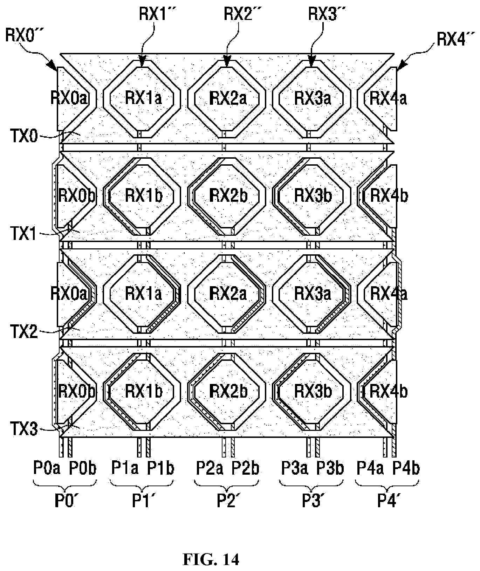

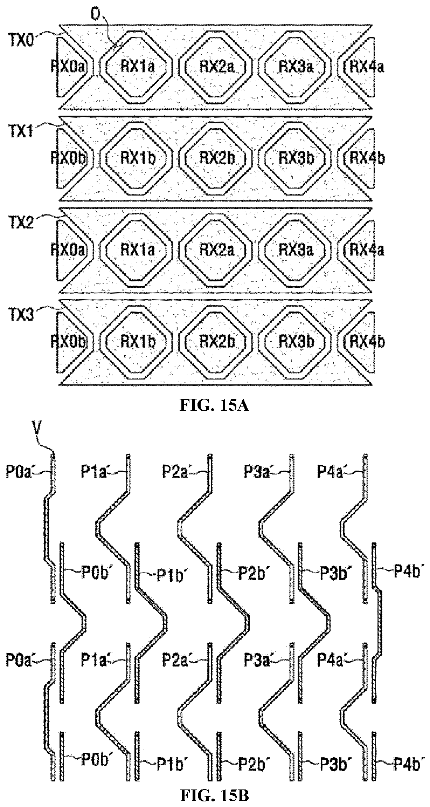

FIG. 14 is a plan view of a portion of another embodiment of the touch sensor 10 shown in FIG. 2. FIGS. 15A and 15B are plan views in which the touch sensor shown in FIG. 14 is separated by layers.

Compared to the touch sensor of the embodiments of FIGS. 8 to 10, the touch sensor according to another embodiment of the present invention shown in FIGS. 14 to 15 has a difference in a plurality of receiving electrodes RX1", RX2", RX3", and RX4". In particular, a plurality of connection patterns P0', P1', P2', P3', and P4' included in the respective receiving electrodes RX0", RX1", RX2", RX3", and RX4" differ in arrangement structure and shape. Hereinafter, the arrangement structure and shape of each of the connection patterns P0', P1', P2', P3', and P4' will be described in detail. Descriptions of remaining configurations will refer to the above descriptions.

Each of the connection patterns P0', P1', P2', P3', and P4' includes the first connection patterns P0a', P1a', P2a', P3a', and P4a' and the second connection patterns P0b', P1b', P2b', P3b', and P4b'.

Each of the first connection patterns P0a', P1a', P2a', P3a', and P4a' electrically connects the two receiving electrode patterns RX0a, RX1a, RX2a, RX3a, and RX4a of the first group. Each of the first connection patterns P0a', P1a', P2a', P3a', and P4a' does not overlap with the second group of receiving electrode patterns RX0b, RX1b, RX2b, RX3b, and RX4b to be between the two receiving electrode patterns. For example, at least a portion of each of the first connection patterns P0a', P1a', P2a', P3a', and P4a' is disposed between the receiving electrode pattern RX0b, RX1b, RX2b, RX3b, and RX4b of the second group and driving electrode TX0, TX1, TX2, and TX3 to be immediately adjacent to the receiving electrode pattern RX0b, RX1b, RX2b, RX3b, and RX4b of the second group not to overlap with the receiving electrode pattern RX0b, RX1b, RX2b, RX3b, and RX4b of the second group. Meanwhile, the remaining portions of each of the first connection patterns P0a', P1a', P2a', P3a', and P4a' may be disposed to overlap the driving electrodes TX0, TX1, TX2, and TX3.

Each of the second connection patterns P0b', P1b', P2b', P3b', and P4b' electrically connects the two receiving electrode patterns RX0b, RX1b, RX2b, RX3b, and RX4b of the second group. Each of the first connection patterns P0b', P1b', P2b', P3b', and P4b' do not overlap with the second group of receiving electrode patterns Rx0a, RX1a, RX2a, RX3a, and RX4a to be between the two receiving electrode patterns. For example, at least a portion of each of the second connection patterns P0b', P1b', P2b', P3b', and P4b' is disposed between the receiving electrode pattern RX0a, RX1a, RX2a, RX3a, and RX4a of the second group and driving electrode TX0, TX1, TX2, and TX3 to be immediately adjacent to the receiving electrode pattern RX0a, RX1a, RX2a, RX3a, and RX4a of the first group not to overlap with the receiving electrode pattern RX0a, RX1a, RX2a, RX3a, and RX4a of the first group. Meanwhile, the remaining portions of each of the second connection patterns P0b', P1b', P2b', P3b', and P4b' may be disposed to overlap the driving electrodes TX0, TX1, TX2, and TX3.

The touch sensor according to another embodiment of the present invention, compared to the touch sensor according to an embodiment of the present invention shown in FIGS. 8 to 10, has an advantage in that a capacitance value may be reduced between the first connection pattern and the second group of the receiving electrode pattern or the second connection pattern and the first group of the receiving electrode pattern.

Meanwhile, although not shown as a separate drawing, the dummy pattern DX1a shown in FIGS. 12 to 13 may be applied to the touch sensor according to other embodiments of the present invention.

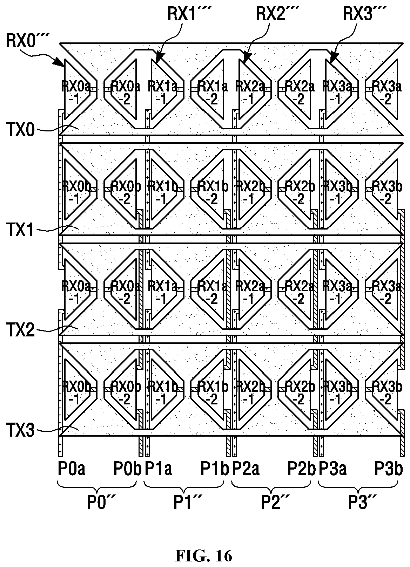

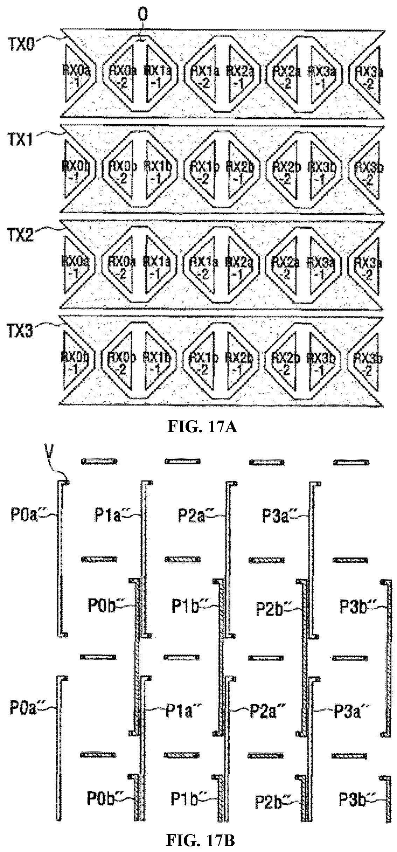

FIG. 16 is a plan view of a portion of another embodiment of the touch sensor 10 shown in FIG. 2. FIGS. 17A and 17B are plan views in which the touch sensor is shown in FIG. 16 is separated by layers.

Compared to the touch sensor of the embodiments of FIGS. 8 to 10, a touch sensor according to another embodiment of the present invention shown in FIGS. 16 and 17 has a difference in a plurality of receiving electrodes RX0‴, RX1‴, RX2"', RX3"'. In particular, a plurality of receiving electrode patterns Rx0a-1, RX0a-2, RXOb-1, RX0b-2, RX1a-1, RX1a-2, RX1b-1, RX1b-2, RX2a-1, RX2a-2, RX2b-1, RX2b-2, RX3a-1, RX3a-2, RX3b-1, and RX3b-2 of each receiving electrode Rx0‴, RX1"', RX2"', and RX3‴ and the plurality of connection patterns P0", P1", P2", and P3" are different in structure and arrangement shape. Hereinafter, the structure and arrangement of the receiving electrode patterns Rx0a-1, RX0a-2, RXOb-1, RX0b-2, RX1a-1, RX1a-2, RX1b-1, RX1b-2, RX2a-1, RX2a-2, RX2b-1, RX2b-2, RX3a-1, RX3a-2, RX3b-1, and RX3b-2 included in each receiving electrode Rx0‴, RX1"', RX2"', and RX3‴ and connection patterns P0", P1", P2", and P3" will be described in detail. Descriptions of remaining configurations will refer to the above descriptions.

The plurality of receiving electrode patterns Rx0a-1, RX0a-2, RXOb-1, RX0b-2, RX1a-1, RX1a-2, RX1b-1, RX1b-2, RX2a-1, RX2a-2, RX2b-1, RX2b-2, RX3a-1, RX3a-2, RX3b-1, and RX3b-2 of each receiving electrode Rx0‴, RX1"', RX2"', and RX3‴ includes receiving electrode patterns Rx0a-1, RX0a-2, RX1a-1, RX1a-2, RX2a-1, RX2a-2, RX3a-1, and RX3a-2 of the first group and receiving electrode patterns RXOb-1, RX0b-2, RX1b-1, RX1b-2, RX2b-1, RX2b-2, RX3b-1, and RX3b-2 of the second group alternately arranged one by one along the second direction. The first group of receiving electrode patterns Rx0a-1, RX0a-2, RX1a-1, RX1a-2, RX2a-1, RX2a-2, RX3a-1, and RX3a-2 and the second group of receiving electrode patterns RxOb-1, RX0b-2, RX1b-1, RX1b-2, RX2b-1, RX2b-2, RX3b-1, and RX3b-2 may be electrically isolated from each other.

Each of the first group of receiving electrode patterns RXOa-1, RX0a-2, RX1a-1, RX1a-2, RX2a-1, RX2a-2, RX3a-1, and RX3a-2 includes the first receiving electrode patterns RXOa-1, RX1a-1, RX2a-1, and RX3a-1 and second receiving electrode patterns RX0a-2, RX1a-2, RX2a-2, and RX3a-2. The first receiving electrode patterns RXOa-1, RX1a-1, RX2a-1, and RX3a-1, and the second receiving electrode patterns RX0a-2, RX1a-2, RX2a-2, and RX3a-2 are respectively disposed adjacent to each other within the two openings O in the first direction along the corresponding driving electrodes TX0 and TX2. One first or second receiving electrode pattern is disposed in the openings defined at both edges among the plurality of openings O of each the driving electrode TX0, TX1, TX2, and TX3. The second receiving electrode pattern of the receiving electrode pattern which is one of the receiving electrodes of the first group among the plurality of receiving electrodes RX0‴, RX1"', RX2"', and RX3‴ and the first receiving electrode pattern of the receiving electrode patterns which is one of another receiving electrode of the first group among the plurality of receiving electrodes RX0 ‴, RX1"', RX2"', and RX3‴ are disposed in the remaining openings together but spaced apart from each other.

Each of the connection patterns P0", P1", P2", and P3" includes a first connection patterns P0a" , P1a" , P2a" , and P3a" for electrically connecting a first group of receiving electrode patterns Rx0a-1, RX0a-2, RX1a-1, RX1a-2, RX2a-1, RX2a-2, RX3a-1, and RX3a-2 and a second connection patterns P0b" , P1b" , P2b" , and P3b" for electrically connecting the second group of receiving electrode patterns RxOb-1, RX0b-2, RX1b-1, RX1b-2, RX2b-1, RX2b-2, RX3b-1, and RX3b-2.

Each of the first connection patterns P0a" , P1a" , P2a" , and P3a" and the second connection patterns P0b" , P1b" , P2b" , and P3b" is configured to connect two adjacent receiving electrode patterns with a shortest distance for each group. For example, each of the first connection patterns P0a" , P1a" , P2a" , and P3a" and the second connection patterns P0b" , P1b" , P2b" , and P3b" have one end connected to one lower end of one receiving electrode pattern among the two adjacent receiving electrode patterns of one group, and the other end connected to one upper end of the other receiving electrode pattern. The rest portion, except for the one end and the other end, has a shape extending along the second direction. The rest portion does not overlap another group of receiving electrode patterns disposed between the one receiving electrode pattern and the other receiving electrode pattern. The rest portion is disposed to overlap the opening O of the driving electrode with the largest cross-sectional area.

In addition, each of the first connection patterns P0a" , P1a" , P2a" , and P3a" further includes the receiving electrode patterns to connect electrically the first receiving electrode patterns and the second receiving electrode patterns of the receiving electrode patterns of the first group. Each of the second connection patterns P0b", P1b", P2b", and P3b" further includes the receiving connection patterns to connect electrically the first receiving electrode patterns and the second receiving electrode patterns of the receiving electrode patterns of the second group.

Compared to the touch sensor of the embodiment of the present invention shown in FIGS. 8 to 10, the touch sensor according to another embodiment of the present invention has an advantage of reducing a capacitance value between the first connection patterns and the second group of receiving electrode patterns or reducing a capacitance value between the second connection patterns and the receiving electrode pattern of the first group of receiving electrode patterns. The touch sensor may also reduce a resistance value of each connection pattern.

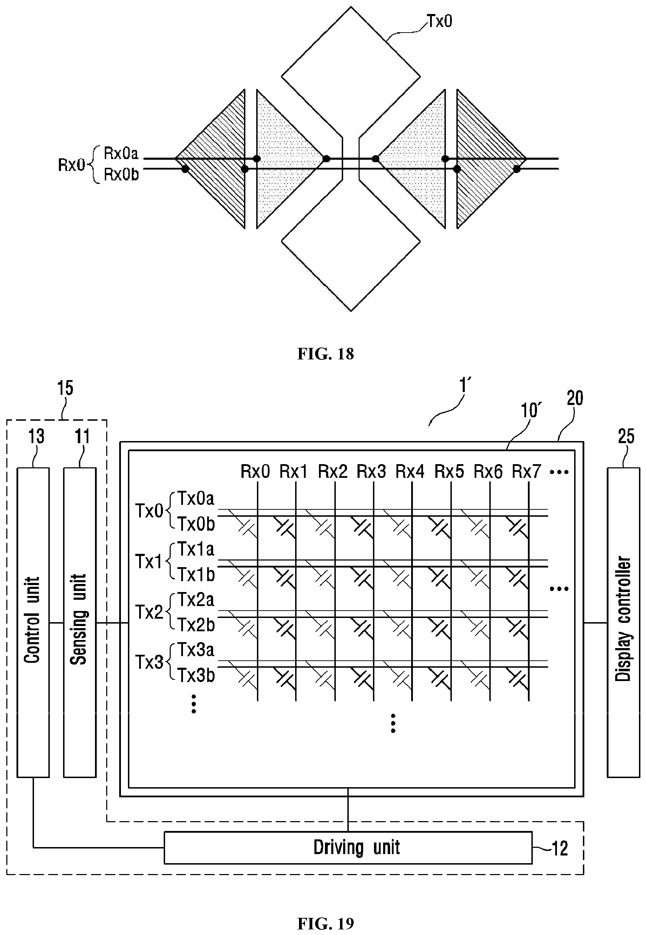

FIG. 18 is a plan view of a portion of another embodiment of the touch sensor 10 shown in FIG. 2.

The touch sensor according to another embodiment of the present invention shown in FIG. 18 includes a plurality of driving electrodes Tx0 and a plurality of receiving electrodes Rx0.

Each driving electrode Tx0 includes diamond-shaped pattern portions arranged along one direction, and each driving electrode Tx0 includes connection pattern portions to connect two adjacent pattern portions among the pattern portions.

Each receiving electrode Rx0 includes a first electrode portion Rx0a and a second electrode portion Rx0b arranged along another direction different from the one direction. The first electrode portion Rx0a and the second electrode portion Rx0b may each have a triangular shape. The first electrode portion Rx0a and the second electrode portion Rx0b may be disposed adjacent to each other to form a diamond shape as a whole.

The first electrode portion Rx0a is disposed closer to the driving electrode Tx0 than the second electrode portion Rx0b. The second electrode portion Rx0b is disposed closer to the other driving electrode than the first electrode portion Rx0a.

The first electrode portion Rx0a may be electrically connected through a plurality of conductive traces. The second electrode portion Rx0b may also be electrically connected through the plurality of conductive traces.

FIG. 19 is a schematic diagram of a touch input device according to another embodiment of the present invention.

Referring to FIG. 19, the touch input device 1' according to another embodiment of the present invention includes a touch sensor 10', a display panel 20, a touch controller 15 for controlling the touch sensor 10, and a display controller 20 for controlling the display panel 20. Here, other configurations except for the touch sensor 10' are the same as those of the touch input device 1 shown in FIG. 2. The touch sensor 10' will be described in detail below.

The touch sensor 10' includes a plurality of driving electrodes Tx0, Tx1, Tx2... and a plurality of receiving electrodes Rx0, Rx1, Rx2, Rx3....

The plurality of driving electrodes Tx0, Tx1, Tx2... and the plurality of receiving electrodes Rx0, Rx1, Rx2, Rx3... may be arranged to cross each other. A mutual capacitance may be formed between the plurality of driving electrodes Tx0, Tx1, Tx2... and the plurality of receiving electrodes Rx0, Rx1, Rx2, Rx3... particularly at intersections thereof. The capacitance may be changed by an object in contact with or in proximity to a surface of the touch input device.

Each of the driving electrodes Tx0, Tx1, Tx2... extends in a first direction, and each receiving electrode Rx0, Rx1, Rx2, Rx3... extends in a second direction different from the first direction. Here, the second direction may be a direction perpendicular to the first direction.

Each of the plurality of driving electrodes Tx0, Tx1, Tx2, Tx3... includes a pair of driving electrode portions Tx0a and Tx0b, Tx1a and Tx1b, Tx2a and Tx2b, Tx3a and Tx3b.... The pair of driving electrode portions Tx0a and Tx0b, Tx1a and Tx1b, Tx2a and Tx2b, Tx3a and Tx3b... include a first driving electrode portion Tx0a, Tx1a, Tx2a, Tx3a... and a second driving electrode portion Tx0b, Tx1b, Tx2b, Tx3b....

The first driving electrode portions Tx0a, Tx1a, Tx2a, Tx3a... among the plurality of driving electrodes Tx0, Tx1, Tx2, Tx3.... may be arranged to form mutual capacitance (cm) with some receiving electrodes Rx0, Rx2, Rx4, Rx6... among the plurality of receiving electrodes Rx0, Rx1, Rx2.... The second driving electrode portions Tx0b, Tx1b, Tx2b, Tx3b... among the plurality of driving electrodes Tx0, Tx1, Tx2, Tx3... may be arranged to form mutual capacitance with the remaining receiving electrodes Rx1, Rx3, Rx5, Rx7... among the plurality of receiving electrodes Rx0, Rx1, Rx2....

The first driving electrode portions Tx0a, Tx1a, Tx2a, Tx3a... among the plurality of driving electrodes Tx0, Tx1, Tx2, Tx3 ... may be disposed to be immediately adjacent to some receiving electrodes Rx0, Rx2, Rx4, Rx6 ... among the plurality of receiving electrodes Rx0, Rx1, Rx2 .... The first driving electrode portions Tx0a, Tx1a, Tx2a, Tx3a may be arranged not to be immediately adjacent but to be spaced a predetermined distance from the remaining receiving electrodes Rx1, Rx3, Rx5, Rx7 ... among the plurality of receiving electrodes Rx0, Rx1, Rx2 .... Here, at least one different electrode may be disposed between the first driving electrode portions Tx0a, Tx1a, Tx2a, Tx3a... and the remaining receiving electrodes Rx1, Rx3, Rx5, Rx7 .... At least one different electrode may be some receiving electrodes Rx0, Rx2, Rx4, Rx6....

The second driving electrode portions Tx0b, Tx1b, Tx2b, Tx3b ... among the plurality of driving electrodes Tx0, Tx1, Tx2... may be disposed to be immediately adjacent to the remaining receiving electrodes Rx1, Rx3, Rx5, Rx7 ... among the plurality of receiving electrodes Rx0, Rx1, Rx2 .... The second driving electrode portions Tx0b, Tx1b, Tx2b, Tx3b ... may be disposed not to be immediately adjacent to but spaced apart by a predetermined distance from some receiving electrodes Rx0, Rx2, Rx4, Rx6... among the plurality of receiving electrodes Rx0, Rx1, Rx2 .... Here, at least one different electrode may be disposed between the second driving electrode portions Tx0b, Tx1b, Tx2b, Tx3b... and some receiving electrodes Rx0, Rx2, Rx4, Rx6... At least one different electrode may be the remaining receiving electrodes Rx1, Rx3, Rx5, Rx7....

A driving signal may be applied to each driving electrode Tx0, Tx1, Tx2, Tx3.... Here, a first driving signal is applied to the first driving electrode portion Tx0a, Tx1a, Tx2a, Tx3a... of the respective driving electrodes Tx0, Tx1, Tx2, Tx3.... A second driving signal is applied to the second driving electrode portion Tx0b, Tx1b, Tx2b, Tx3b.... The first and second driving signals may be applied simultaneously or at different times. The second driving signal may be obtained only from the 180-degree phase shifting of the first driving signal.

When the first driving signal and the second driving signal are simultaneously applied to the first driving electrode portion Tx0a and the second driving electrode portion Tx0b of the driving electrode Tx0, a predetermined signal is output from the receiving electrode Rx0 that crosses the driving electrode Tx0. The output signal includes the first capacitance information between the first driving electrode portion Tx0a and the receiving electrode Rx0 and capacitance information based on the second capacitance information between the second driving electrode portion Tx0b and the receiving electrode Rx0. The capacitance information may be obtained by subtracting the second capacitance information from the first capacitance information.

The touch controller 15 may determine whether or not an object is touched and/or the touch position based on a signal output from the plurality of receiving electrodes Rx0, Rx1, Rx2, Rx3....

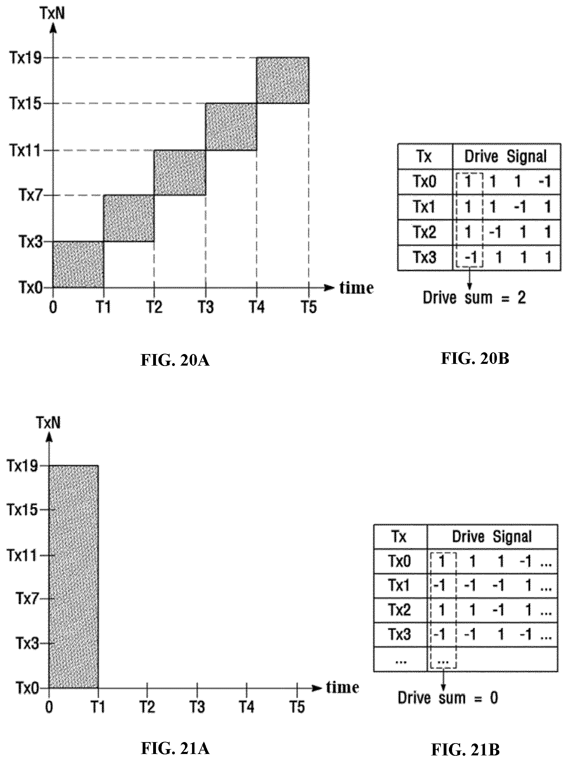

The touch input device 1' shown in FIG. 19, may prevent occurrence of flicker in the display panel 20 due to driving of the touch sensor 10' and may make a shortened driving time. Here, the flicker is a phenomenon, in which a portion of the display screen rapidly flickers or vibrates, because the driving signal affects the display panel when the driving signal is electrically applied to a driving electrode of the touch sensor 10'. It will be described in detail with reference to FIGS. 20 to 21.

FIG. 20A is a graph showing a multi-driving which is performed for each of four driving electrodes of the touch input device in FIG. 2. FIG. 20B is a table showing an example of a driving signal (or a driving code) that is simultaneously applied to four driving electrodes Tx0, Tx1, Tx2, and Tx3 during the multi-driving in FIG. 20A.

As shown in FIG. 20A, a drive sum of the driving signals becomes '2' when the driving signals are shown in FIG. 20B are simultaneously applied to four driving electrodes Tx0, Tx1, Tx2, and Tx3 among 20 driving electrodes Tx0 to Tx19 during an arbitrary time interval 0 to T1. Here, for example, when the driving voltage applied to each driving electrode is 10 [V], a total driving voltage of 20 [V] corresponding to 2 * 10 [V] may affect the display panel which may cause the flicker on the display screen. Furthermore, as the number of simultaneously driven driving electrodes becomes greater than four, the drive sum of the driving signals increases. Therefore, the total drive voltage also increases and causes a severe flicker on the display screen.

On the other hand, in the touch input device shown in FIG. 19, there is an advantage in that the above-described flicker problem in the display panel does not occur even when the touch controller 15 controls to simultaneously apply a driving signal to more than four electrodes or all the driving electrodes among the plurality of driving electrodes Tx0, Tx1, Tx2.... It will be described in detail with reference to FIGS. 21A and 21B.

FIG. 21A is a graph showing the multi-driving of all driving electrodes in the touch input device shown in FIG. 19. FIG. 21B is a table showing an example of a driving signal (or driving code) applied to all driving electrodes Tx0, Tx1, Tx2, Tx3,... simultaneously driven during the multi-driving in FIG. 21A.

As shown in FIG. 21A, when the driving signals shown in FIG. 21B are simultaneously applied to all driving electrodes Tx0, Tx1, Tx2 ... of the touch sensor 10' for a predetermined time interval (0 to T1), the drive sum of the driving signals (drive sum) always becomes '0'. This is because the driving signals simultaneously applied to a portion of driving electrodes Tx0a, Tx1a, Tx2a, Tx3a, ... and the driving signals simultaneously applied to the remaining portion of driving electrodes Tx0b, Tx1b, Tx2b, Tx3b ... have the same size but the phase is reversed by 180 degrees only. In this way, since the drive sum of the driving signals becomes '0', the display panel is not affected at all. Therefore, there is an advantage in that flicker does not occur on the display screen when the display panel is working.

Further, as shown in FIG. 21A, the touch input device of FIG 19, the touch input device may reduce the mutual driving time to 1/5 compared to the graph in FIG. 20A because the touch controller 15 may drive simultaneously all or more than four driving electrodes of the plurality of driving electrodes Tx0, Tx1, Tx2.... Furthermore, because the touch input device may reduce a turn-on time of the analog front end (AFE), a power consumption of the touch input device also may be reduced.

Also, the touch input device 1' may remove a noise signal caused by the LGM when the touch input device 1' is in the LGM state.

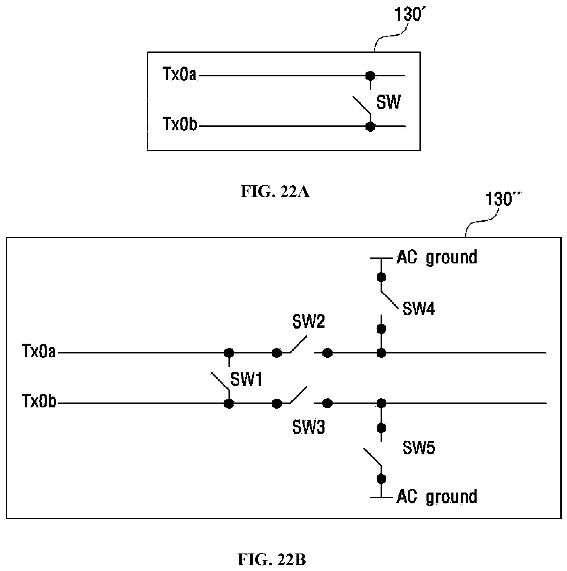

FIGS. 22A and 22B are views for explaining a driving circuit unit 130' according to an embodiment of the touch controller 15 shown in FIG. 8.

Referring to FIG. 22A, the driving circuit unit 130' includes a switch element SW for electrically shorting or opening a pair of driving electrode portions Tx0a and Tx0b of each driving electrode Tx0. The switch element SW is controlled by a controller (not shown). When the switch element SW is closed, a pair of driving electrode portions Tx0a and Tx0b of each driving electrode Tx0 are electrically connected. Meanwhile, although not shown in the drawings, the switch element may be disposed between a pair of driving electrode portions of another driving electrode.

According to the driving circuit unit 130', the switch element SW may be controlled to electrically connect the pair of driving electrode portions Tx0a and Tx0b. This control method may be used when driving the touch sensor 10' shown in FIG. 19 in the self-sensing mode or driving the stylus-sensing mode for sensing a pen signal output from a stylus.

Referring to FIG. 22B, the driving circuit unit 130" includes a plurality of switch elements SW1, SW2, SW3, SW4, and SW5. The first switch element SW1 performs the same role as the switch element SW shown in FIG. 22A. The first switch element SW1 is connected between the pair of driving electrode portions Tx0a and Tx0b. The first switch element SW1 may be shorted or opened according to the control of a controller (not shown).

The driving circuit unit 130" controls the second to fifth switch elements SW2, SW3, SW4, and SW5 to select one driving electrode portion from the pair of driving electrode portions Tx0a and Tx0b of each driving electrode Tx0.

The second switch element SW2 may be connected to one end of the first switch element SW1, and the third switch element SW3 may be connected to the other end of the first switch element SW1.

The fourth switch element SW4 is connected between an output terminal of the second switch element SW2 and an AC ground. The fifth switch element SW5 is connected between an output terminal of the third switch element SW3 and the AC ground.

On the other hand, depending on which driving electrode portion is selected from the pair of driving electrode portions Tx0a and Tx0b, the second and fifth switch elements SW2 and SW5 or the third and fourth switch elements SW3 and SW4 may be omitted.

The driving circuit unit 130" may control the first switch element SW1 to electrically connect the pair of driving electrode portions Tx0a and Tx0b so that the touch sensor 10' shown in FIG. 19 may be driven in the self-sensing mode or the stylus-sensing mode. In addition, by controlling the second to fifth switch elements SW2, SW3, SW4, and SW5, it is possible to control that one driving electrode portion among the pair of driving electrode portions Tx0a and Tx0b is selected, and then the one driving electrode portion is connected to the other electronic device.

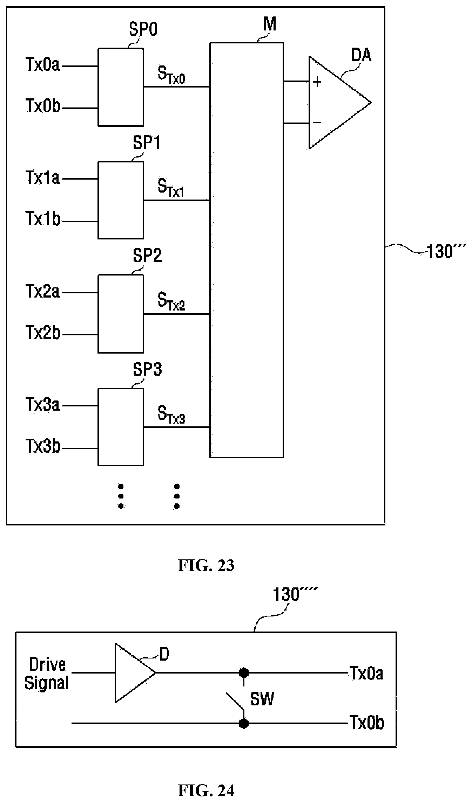

FIG. 23 is a view for explaining a driving circuit unit 130‴ according to another embodiment of the touch controller 15 shown in FIG. 8.

Referring to FIG. 23, when the touch sensor 10' is working in the self-sensing mode or the pen-sensing mode, a plurality of driving electrodes Tx0, Tx1, Tx2... of the driving circuit unit 130‴ may perform a function to output a predetermined signal.

The driving circuit unit 130‴ may include a plurality of switching units SP0, SP1, SP2, SP3..., a multiplexer M, and a differential amplifier DA.

Each switching unit SP0 electrically connects or electrically opens a pair of driving electrode portions Tx0a and Tx0b of each driving electrode to each other. A pair of input terminals of each signal processor SP0 is electrically connected to the pair of driving electrode portions Tx0a and Tx0b. One output terminal of each signal processor SP0 is connected to one of the plurality of input terminals of the multiplexer M. The other switching units SP1, SP2, SP3... are connected in the same manner.

The multiplexer M includes a plurality of input terminals to be connected to the output terminals of the plurality of switching units SP0, SP1, SP2, SP3... on a one-to-one basis, and the multiplexer M includes at least two output terminals. The two output terminals are respectively connected to corresponding two input terminals of the differential amplifier DA.

The driving circuit unit 130‴ may remove a display noise caused by driving of the display panel 20 shown in FIG. 19. Specifically, when the touch sensor 10' shown in FIG. 19 is working as the pen sensing mode for sensing a pen signal output from the stylus, the plurality of switching units SP0, SP1, SP2, SP3... make a pair of driving electrode portions Tx0a and Tx0b, Tx1a and Tx1b, Tx2a and Tx2b, Tx3a and Tx3b... of each driving electrode to be electrically connected. The multiplexer M outputs two signals to the differential amplifier DA among a plurality of signals S_{Tx0}, S_{Tx1}, S_{Tx2}, S_{Tx3} ... from a plurality of signal processors SP0, SP1, SP2, SP3.... The differential amplifier DA outputs a differentially amplified signal with two signals which are selected by the multiplexer M. Since most of the display noise caused by the driving of the display panel 20 is removed from the differentially amplified signal, a touch malfunction may be prevented. Touch sensitivity also may be improved.

FIG. 24 is a view for explaining a driving circuit unit 130ʺʺ according to another embodiment of the touch controller 15 shown in FIG. 8.

Referring to FIG. 24, the driving circuit unit 130ʺʺ may include a driving driver D and a switch element SW.

The driving driver D amplifies a driving signal which is input to an input terminal and then outputs the driving signal. An output terminal of the driving driver D is connected to the first driving electrode portion Tx0a of each driving electrode.

The switch element SW has one end connected to the output terminal of the driving driver D and the other end connected to the second driving electrode portion Tx0b of each driving electrode. The switch element SW may be closed or opened by the touch controller 15.

The driving circuit unit 130ʺʺ may be used when the touch sensor 10' shown in FIG. 19 is working in the self-sensing mode or working in the pen-driving mode for driving the stylus.

Meanwhile, although not shown in a separate drawing, the driving circuit unit may be bundled to use a multiplexer (MUX), and then the driving circuit unit may be worked by a single-driving driver. In this case, the driving driver may be an inverter-type logic circuit or a buffer using an analog amplifier.

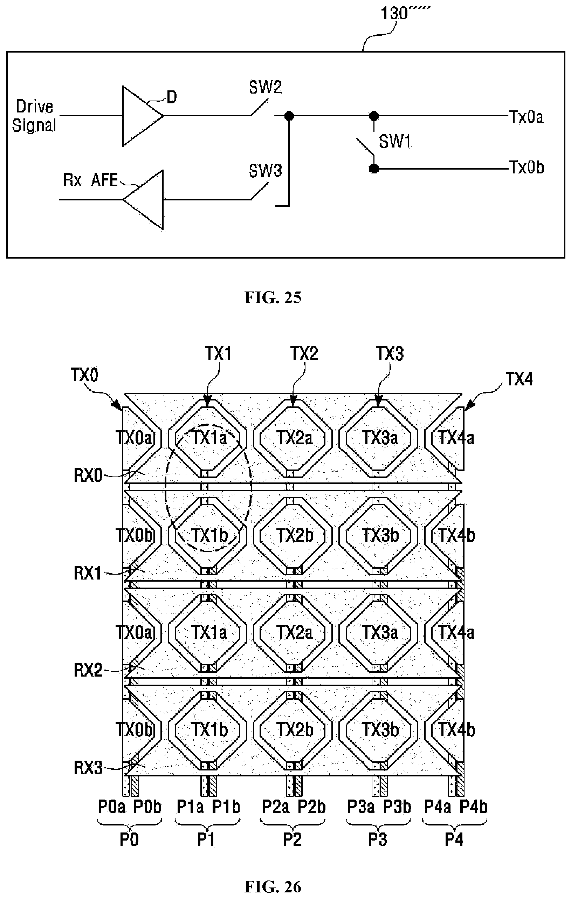

FIG. 25 is a view for explaining a driving circuit unit 130‴ʺ according to another embodiment of the touch controller 15 shown in FIG. 19.

The driving circuit unit 130‴ʺ includes a driving driver D, a plurality of switch elements SW1, SW2, and SW3, and a reception analog front-end Rx AFE.

The driving driver D amplifies a driving signal which is input to an input terminal and then outputs the driving signal. An output terminal of the driving driver D is connected to the first driving electrode portion Tx0a of each driving electrode.

The first switch element SW1 has one end connected to the output terminal of the driving driver D and the other end connected to the second driving electrode portion Tx0b of each driving electrode. The first switch element SW1 may be closed or opened by the touch controller 15.

The second switch element SW2 is connected between the driving driver D and the first driving electrode portion Tx0a. When the second switch element SW2 is turned on, the driving driver D and the first driving electrode portion Tx0a are electrically connected. when the second switch element SW2 is turned off, the driving driver D and the first driving electrode portion Tx0a are electrically disconnected.

The third switch element SW3 is connected between the reception analog front-end Rx AFE and the first driving electrode portion Tx0a. When the third switch element SW3 is turned on, the reception analog front-end Rx AFE and the first driving electrode portion Tx0a are electrically connected. When the third switch element SW3 is turned off, the reception analog front-end Rx AFE and the first driving electrode portion Tx0a are electrically disconnected.

When the touch controller 15 performs a self-sensing using each driving electrode of the touch sensor, the touch controller 15 may turn on the first switch element SW1 to connect the first driving electrode portion Tx0a and the second driving electrode portion Tx0b. The touch controller 15 may turn on the second switch element SW2 to connect electrically the driving driver D and the first driving electrode portion Tx0a. The touch controller 15 may turn off the third switch element SW. The self-sensing driving signal, which is amplified by the driving driver D, may be simultaneously applied to the first driving electrode portion Tx0a and the second driving electrode portion Tx0b by the control of the touch controller 15.

When the touch controller 15 performs a stylus sensing using each driving electrode of the touch sensor to sense the pen signal emitted from the stylus, the touch controller 15 may turn on the first switch element SW1 to connect electrically the first driving electrode portion Tx0a and the second driving electrode portion Tx0b. The touch controller 15 may turn on the third switch element SW3 to connect electrically the reception analog front-end Rx AFE and the first driving electrode portion Tx0a. The touch controller 15 may turn off the second switch element SW2. The pen signal, which is received by the first driving electrode portion Tx0a and the second driving electrode portion Tx0b, may be applied to the reception analog front-end Rx AFE by the control of the touch controller 15.

Meanwhile, although not shown in separate drawings, additional switch elements in FIGS. 22A and 22B may be worked together in addition to the plurality of switch elements SW1, SW2, and SW3. In addition, an additional multiplexer M shown in FIG. 23 may be disposed between the third switch element SW3 and the reception analog front-end Rx AFE.

FIG. 26 is a plan view of a portion of an embodiment of a touch sensor 10' shown in FIG. 19.

An embodiment of the touch sensor 10' shown in FIG. 26 has the same structure as that of the plurality of electrodes of the embodiment of the touch sensor 10 shown in FIG. 8. However, the touch sensor 10' and the touch sensor 10 have a difference in that the driving electrodes TX0, TX1, TX2, TX3, and TX4 to apply driving signals and receiving electrodes Rx0, RX1, RX2, and RX3 to output the receiving signal are reversely configured.

Referring to FIG. 26, the touch controller 15 shown in FIG. 19 may control so that predetermined driving signals may be simultaneously applied to connection patterns P0, P1, P2, P3, P4... of the plurality of driving electrodes TX0, TX1, TX2, TX3, TX4.... Here, the driving signal applied to the second connection pattern POb of each connection pattern P0 is an inverted driving signal which is a signal obtained by 180 degrees inverting the phase of the driving signal to be applied to the first connection pattern P0a.

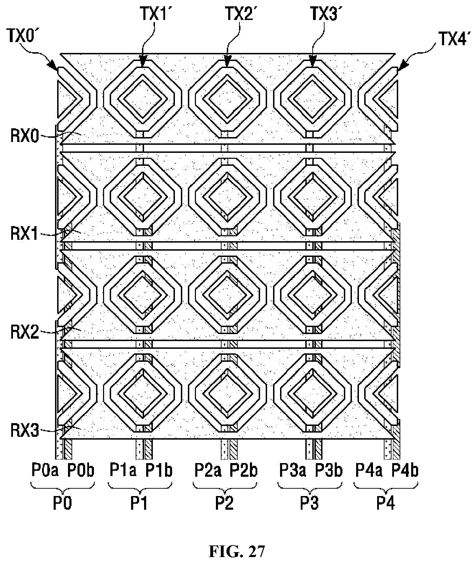

FIG. 27 is a plan view of a portion of another embodiment of the touch sensor 10' shown in FIG. 19.

Another embodiment of the touch sensor 10' shown in FIG. 27 has the same structure as that of the plurality of electrodes of the embodiment of the touch sensor 10 shown in FIG 11. However, the touch sensor 10' and the touch sensor 10 have a difference in that the driving electrodes to be applied to driving signals and the receiving electrodes to output the receiving signals are reversely configured.

Referring to FIG. 27, the touch controller 15 shown in FIG. 19 may control so that predetermined driving signals are simultaneously applied to connection patterns P0, P1, P2, P3, P4... of the plurality of driving electrodes TX0', TX1', TX2', TX3', TX4' .... Here, the driving signal applied to the second connection pattern POb of each connection pattern P0 is an inverted driving signal which is a signal obtained by 180 degrees inverting the phase of the driving signal to be applied to the first connection pattern P0a.

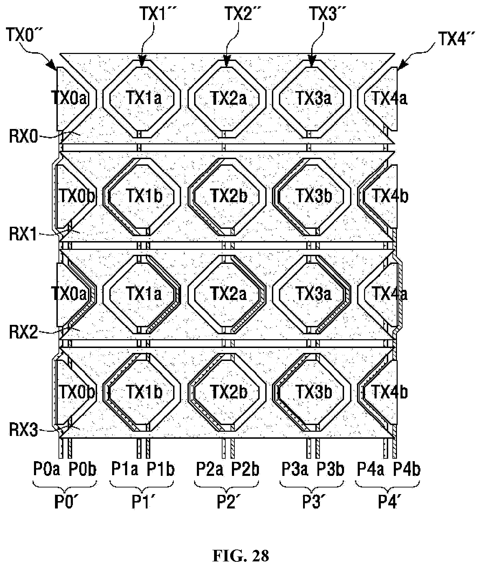

FIG. 28 is a plan view of a portion of another embodiment of the touch sensor 10' shown in FIG. 19.

Another embodiment of the touch sensor 10' shown in FIG. 28 has the same structure as that of the plurality of electrodes of the embodiment of the touch sensor 10 shown in FIG. 14. However, the touch sensor 10' and the touch sensor 10 have a difference in that the driving electrodes to be applied to driving signals and the receiving electrodes to output the receiving signals are reversely configured.

Referring to FIG. 28, the touch controller 15 shown in FIG. 19 may control so that predetermined driving signals are simultaneously applied to connection patterns P0', P1', P2', P3', P4'... of the plurality of driving electrodes TX0", TX1", TX2", TX3", TX4".... Here, the driving signal applied to the second connection pattern POb of each connection pattern P0' is an inverted driving signal which is a signal obtained by 180 degrees inverting the phase of the driving signal to be applied to the first connection pattern P0a.

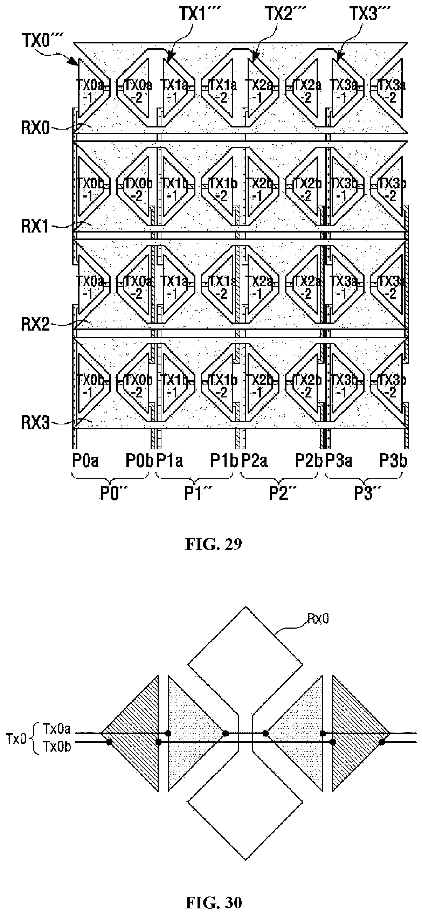

FIG. 29 is a plan view of a portion of another embodiment of the touch sensor 10' shown in FIG. 19.

Another embodiment of the touch sensor 10' shown in FIG. 29 has the same structure as that of the plurality of electrodes of the embodiment of the touch sensor 10 shown in FIG. 16. However, the touch sensor 10' and the touch sensor 10 have a difference in that the driving electrodes to be applied to driving signals and the receiving electrodes to output the receiving signals are reversely configured.

Referring to FIG. 29, the touch controller 15 shown in FIG. 19 may control so that predetermined driving signals are simultaneously applied to connection patterns P0", P1", P2", P3" ... of the plurality of driving electrodes TX0‴, TX1‴, TX2‴, TX3‴.... Here, the driving signal applied to the second connection pattern POb of each connection pattern P0" is an inverted driving signal which is a signal obtained by 180 degrees inverting the phase of the driving signal to be applied to the first connection pattern P0a.

FIG. 30 is a plan view of a portion of another embodiment of the touch sensor 10' shown in FIG. 19.

Another embodiment of the touch sensor shown in FIG. 30 has the same structure as that of the plurality of electrodes of the embodiment of the touch sensor 10 shown in FIG. 18. However, the touch sensors have a difference in that the driving electrodes to be applied to driving signals and the receiving electrodes to output the receiving signals are reversely configured.

Referring to FIG. 30, the touch controller 15 shown in FIG. 19 may control so that predetermined driving signals are simultaneously applied to the first driving electrode portion Tx0a and the second driving electrode portion Tx0b of the plurality of driving electrodes Tx0. Here, the driving signal applied to the first driving electrode portion Tx0a is an inverted driving signal which is a signal obtained by 180 degrees inverting the phase of the driving signal to be applied to the second driving electrode portion Tx0b.

The touch controller 15 shown in FIG. 19 may receive signals having mutual capacitance variation information from one of the plurality of receiving electrodes RX0, RX1, RX2, RX3... of the touch sensors shown in FIGS. 26 to 30. The touch controller 15 may output differential signals from the received receiving signals. The touch controller 15 may be restored by integrating the differential signals which are receiving signals from the plurality of receiving electrodes RX0, RX1, RX2, RX3 .... The touch controller 15 may determine a touch position of an object based on information on an amount of variation in mutual capacitance of the processed signals which include the codes of the restored receiving signals.

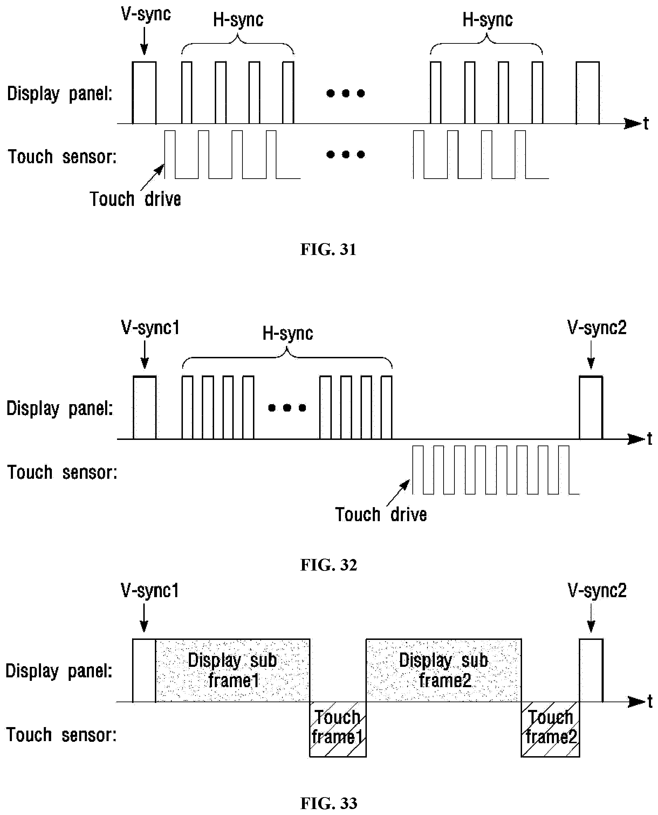

FIG. 31 is a view for explaining a first driving method of touch input devices 1 and 1' shown in FIGS. 2 and 19.

The first driving method shown in FIG. 31 is a driving method of the touch sensors 10 and 10' considering the driving of the display panel 20. This first driving method may be performed by the touch controller 15 of FIGS. 2 and 19.

The first driving method may drive the touch sensor 10 and 10' by synchronizing with at least one horizontal synchronization signal H-sync. The first driving method may drive the touch sensors 10 and 10' for a predetermined time interval after starting the horizontal synchronization signal and applying the horizontal sync signal to the display panel 20. Here, the predetermined time interval may be a time between the time of a horizontal synchronization signal starting and the right before a time of a next horizontal synchronization signal to reach the display panel 20.

Here, the horizontal synchronization signal H-sync is a signal for refreshing one scan line of the display panel 20. Driving of the touch sensors 10 and 10' means that the touch controller 15 applies driving signals to the selected driving electrodes of the touch sensors 10 and 10' and receives sensing signals from the receiving electrodes.

The first driving method may drive the touch sensor 10 and 10' by synchronizing with at least one horizontal synchronization signal H-sync. In the first driving method, the first driving method drives the touch sensors 10 and 10' for a predetermined time interval after the horizontal synchronization signal is applied to the display panel 20. Therefore, the horizontal synchronization signal H-sync is not applied to the display panel 20 while the touch sensor 10 and 10' is working. Therefore, the display noise caused by the driving of the display panel 20 may be minimized.

FIG. 31 shows that the touch sensors 10 and 10' may drive one time during a time interval between two horizontal synchronization signals H-sync adjacent to each other along a time axis. However, the touch sensors 10 and 10' may be driven more than once.

FIG. 32 is a view for explaining a second driving method of the touch input devices 1 and 1' shown in FIGS. 2 and 19.

In the second driving method in FIG. 32, the second driving method is a driving method of the touch sensors 10 and 10' considering the driving of the display panel 20. The second driving method may be performed by the touch controller 15 of FIGS 2 and 19.

The second driving method is a method that completely separates the driving time interval of the touch sensors 10 and 10' from the driving time interval of the display panel 20. For example, the second driving method may control the touch sensors 10 and 10' to be worked after all the horizontal synchronization signals H-sync are driven. Alternatively, although not shown in the drawings, the second driving method may control the horizontal synchronization signals H-sync to be applied after the touch sensors 10 and 10' are worked.

Referring to FIG. 32, a first time interval is configured as one frame of horizontal synchronization signals (H-sync) in a time interval between two vertical synchronization signals (V-sync1 and V-sync2). A second time interval is a time interval in which the touch sensors 10 and 10' are working. In this case, the touch controller 15 shown in FIGS. 2 and 19 may control the first time interval and the second time interval to be separated completely from each other.

Here, the second time interval may be equal to or less than the first time interval. Meanwhile, although not shown in the drawings, the second time interval may precede the first time interval in terms of time. In other words, after the touch sensors 10 and 10' are working first, and then the plurality of horizontal synchronization signals (H-sync) may be applied.

In this second driving method, there is no display update of the display panel 20 while the touch sensor 10 and 10' is working. Therefore, it is an advantage that the display noise caused by the display panel 20 does not affect while the touch sensors 10 and 10' are working. In addition, the second driving method may minimize the influence of flicker from the display panel 20 while the touch sensor 10 and 10' is working.

FIG. 33 is a view for explaining a third driving method of the touch input devices 1 and 1' shown in FIGS 2 and 19.

The third driving method of FIG. 33 is a driving method of the touch sensor 10 and 10' considering the operation of the display panel 20. This third driving method may be performed by the touch controller 15 of FIGS. 2 and 19.

Referring to FIG. 33, the third driving method is a driving method in which a touch report rate is higher than a display refresh rate when the driving timing of the touch sensors 10 and 10' and the driving timing of the display panel 20 are completely separated.

As shown in FIG. 33, the display controller 20 divides the entire time interval in which the horizontal synchronization signals are driven between two vertical synchronization signals V-sync1 and V-sync2 into a first time interval (display subframe 1) and a second time interval (display subframe 2). Then, the touch controller 15 may drive the touch sensors 10 and 10' for a predetermined time interval (touch frame 1) between the two time intervals (display subframe 1 and display subframe 2), or the touch controller 15 may drive the touch sensors 10 and 10' for a predetermined time interval (touch frame 2) between the second time interval (display subframe 2) and the second vertical synchronization signal V-sync 2. Here, when the display refresh rate is 60 Hz, the touch report rate may be 120 Hz.

Meanwhile, although the touch report rate is two times greater than the display refresh rate in FIG. 33, the embodiment of the present invention is not limited thereto. The touch report rate may be 3 times, 4 times ..., or N times of the display refresh rate.

In the third driving method, there is no display update of the display panel 20 while the touch sensors 10 and 10' are working. Therefore, it is advantageous that the touch sensors 10 and 10' are not affected by display noise caused by the display panel 20 while the touch sensors 10 and 10' are working. In addition, the influence of flicker may be minimized in the display panel 20 because of the touch sensors 10 and 10' operation.

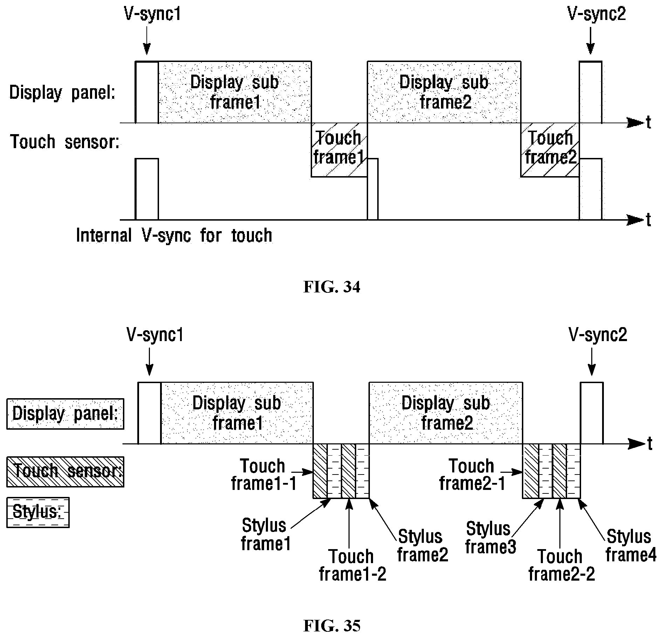

FIG. 34 is a view for explaining a fourth driving method of the touch input devices 1 and 1' shown in FIGS. 2 and 19.

The fourth driving method in FIG. 34 is a driving method of the touch sensors 10 and 10' considering the driving of the display panel 20. This fourth driving method may be performed by the touch controller 15 of FIGS. 2 and 19.

Referring to FIG. 34, the fourth driving method is a driving method in which the touch report rate is higher than the display refresh rate when the driving timing of the touch sensors 10 and 10' and the driving timing of the display panel 20 are completely separated.

As shown in FIG. 34, the display controller 20 divides the entire driving time interval, including horizontal synchronization signals(H-sync), into a first-time interval (display subframe 1) and a second time interval (display subframe 2) between the two vertical synchronization signals V-sync1 and V-sync2. Here, the touch controller 15 receives a vertical synchronization signal (V-sync). The touch controller 15 generates at least one internal signal having a frequency of 1/N times (N is a natural number) or frequency of N times (N is a natural number) based on the vertical synchronization signal V-sync 1. Then, the touch controller 15 may control the timing of the driving signal to be applied to the touch sensors 10 and 10' based on the generated internal signal.

When the internal signal may not be used, the touch controller 15 is required to individually control a plurality of time frames (touch frame 1 and touch frame 2) that the touch sensors 10 and 10' are driven. However, according to the fourth driving method described above, the touch controller 15 may respectively control two or more time intervals which may drive the touch sensors 10 and 10' based on the generated internal signals. It is an advantage that driving control of the touch sensor 10 and 10' is simplified.

Also, in the fourth driving method, there is no display update of the display panel 20 while the touch sensors 10 and 10' are working. Therefore, it is advantageous that the touch sensors 10 and 10' are not affected by the display noise caused by the display panel 20 while the touch sensors 10 and 10' are working. In addition, the influence of flicker may be minimized in the display panel 20 because of the touch sensors 10 and 10' operation.

FIG. 35 is a view for explaining a fifth driving method of the touch input devices 1 and 1' shown in FIGS. 2 and 19.

The fifth driving method in FIG. 35 is a driving method of the touch sensors 10 and 10' considering the driving of the display panel 20. This fifth driving method may be performed by the touch controller 15 of FIGS. 2 and 19.

Referring to FIG. 35, the fourth driving method is a driving method in which the touch report rate is higher than the display refresh rate when the driving timing of the touch sensors 10 and 10' and the driving timing of the display panel 20 are completely separated. The fourth driving method may support not only the touch sensors 10 and 10' but also a stylus.

When simultaneously supporting the touch sensors 10 and 10' and the stylus, the touch controller 15 may drive the touch sensors 10 and 10' by time- dividing the driving/receiving time interval of the touch sensors 10 and 10' and the stylus.

As shown in FIG. 35, the display controller 20 divides the entire driving time interval, including horizontal synchronization signals(H-sync), into a first-time interval (display subframe 1) and a second time interval (display subframe 2) between the two vertical synchronization signals V-sync1 and V-sync2. In this case, the touch controller 15 drives the touch sensors 10 and 10' and drives and receives the stylus for a predetermined time interval between the two time frames (display sub-frame 1 and display sub-frame 2). The touch controller 15 may determine separately the driving time of the sensor and the driving/receiving time of the stylus.

For example, for a predetermined time interval between the two time intervals (display subframe 1 and display subframe 2), the touch sensors 10 and 10' and the stylus may be alternately driven (Touch frame 1-1, Stylus frame 1, Touch frame 1-2, and Stylus frame 2).

Here, an expression of "the touch controller 15 drives the stylus" may mean that the touch controller 15 may control a pen driving signal to the touch sensors (10 and 10) to drive an externally positioned stylus by using the principle of an electric field or a magnetic field. Here, the touch controller 15 may input the pen driving signal to the plurality of the first electrodes or the plurality of the second electrodes of the touch sensors (10 and 10'), otherwise, the touch controller 15 may input the pen driving signal to other electrodes of the touch sensors 10 and 10'.

As another example, the display controller 20 may control the driving of the touch sensors 10 and 10' and the receiving of the stylus alternately to perform repeatedly (e.g. Touch frame 1- 1, Stylus frame 1, Touch frame 1-2, and Stylus frame 2) for a predetermined time interval between the two time intervals (display subframe 1, display subframe 2).

Here, an expression of "the touch controller 15 receives the stylus" may mean that a pen signal from an externally positioned stylus is received using the principle of an electric field or a magnetic field. Here, the touch controller 15 may receive the pen signal from a plurality of the first electrodes or a plurality of the second electrodes of the touch sensors 10 and 10', otherwise, the touch controller 15 may receive the pen signal from other separate electrodes of the touch sensors 10 and 10'.

As another example, the display controller 20 may control the driving of the touch sensors 10 and 10' and the driving and receiving of the stylus alternately to perform repeatedly (e.g. Touch frame 1-1, Stylus frame 1, Touch frame 1-2, and Stylus frame 2) for a predetermined time interval between the two time intervals (display subframe 1 and display subframe 2).

Also, the display controller 20 may control the touch sensors 10 and 10' and the stylus together to drive alternately to perform repeatedly (e.g. Touch frame 2-1, Stylus frame 3, Touch frame 2-2, and Stylus frame 4) during the time interval between the last refresh time interval (display subframe 2) and the next vertical synchronization signal (V-sync 2), and the touch sensor and the stylus may be repeatedly performed (Touch frame 2-1, Stylus frame 3, Touch frame 2-2, and Stylus frame 4). The display controller 20 may control the driving of the touch sensors 10 and 10' and the driving or/and receiving of the stylus alternately to perform repeatedly (e.g. Touch frame2-1, Stylus frame 3, Touch frame 2-2, Stylus frame 4).

When the touch controller 15 controls to make the stylus report rate higher than the touch report rate, the stylus report rate may be N (N is a natural number greater than 1) times of the touch report rate. In FIG. 35, it is assumed that the stylus report rate is twice of the touch report rate. For example, in FIG. 35, when the display refresh rate is 60 Hz, the touch report rate may be 120 Hz, and the stylus report rate may be 240 Hz. In this case, the touch controller 15 may divide the entire time interval for driving the touch sensors 10 and 10' into two (Touch frame1-1 and Touch frame 1-2), and the touch controller 15 drives the stylus (Stylus frame 1) for a predetermined time interval between the divided two time intervals. The touch controller 15 drives the stylus (Stylus frame 2) again for a predetermined time interval after the second driving time interval (Touch frame 1-2).

In this fifth driving method, there is no display update of the display panel 20 while the touch sensors 10 and 10' are working. Therefore, it is advantageous that the touch sensors 10 and 10' are not affected by display noise caused by the display panel 20 while the touch sensors 10 and 10' are working. In addition, the influence of flicker may be minimized in the display panel 20 because of the touch sensors 10 and 10' operation.

## Claims

1. A touch input device (1') comprising a display panel (20), comprising:
a touch sensor (10') comprising a plurality of first electrodes (Rx0, Rx1, Rx2...) and a plurality of second electrodes (Tx0, Tx1, Tx2...) disposed to cross the plurality of first electrodes; and
a touch controller (15) electrically connected to the plurality of first electrodes and the plurality of second electrodes and configured to control the touch sensor,
wherein the second electrode (Tx0) comprises a pair of electrode parts (Tx0a, Tx0b), one (Tx0a) of the pair of electrode parts is disposed adjacent to at least one of the electrodes (Rx0) among the plurality of first electrodes, and the other (Tx0b) of the pair of electrode parts is disposed adjacent to at least one of remaining electrodes (Rx1) among the plurality of first electrodes,
wherein the touch controller (15) is configured to apply at least one driving signal to the plurality of second electrodes and to receive sensing signals from the plurality of first electrodes,
wherein the touch controller (15) comprises a driving circuit unit (130ʺʺ) electrically connected to the plurality of second electrodes,
**characterised in that** the driving circuit unit (130‴ʺ) comprises:
a driving driver (D) configured to amplify the driving signal and output the amplified signal to the one (Tx0a) of the pair of electrode parts of the second electrode;
a first switch element (SW1) configured to electrically connect or open the one (Tx0a) of the pair of electrode parts and the other (Tx0b) of the pair electrode parts;
a second switch element (SW2) connected between the driving driver (D) and the one (Tx0a) of the pair of electrode parts;
a third switch element (SW3) connected to the one of the pair of electrode parts; and
a receive analog front end (Rx AFE) connected to the third switch element (SW3).

2. The touch input device of claim 1,
wherein the touch controller is configured to drive the touch sensor in synchronization with at least one horizontal synchronization signal applied to the display panel and drive the touch sensor for a predetermined time after the horizontal synchronization signal starts to be applied to the display panel.

3. The touch input device of claim 1 or 2,
wherein the touch controller controls a touch report rate of the touch sensor to be the same as a display refresh rate of the display panel.

4. The touch input device of claim 1 or 2,
wherein the touch controller is configured to drive the touch sensor in a time interval different from a time interval in which horizontal synchronization signals are applied to the display panel,
wherein the touch controller controls a touch report rate of the touch sensor to be higher than a display refresh rate of the display panel,
further comprising a display controller configured to control driving of the display panel,
wherein the display controller is configured to drive the display panel by dividing the entire time interval in which the horizontal synchronization signals are applied into at least two-time intervals, and
wherein the touch controller is configured to drive the touch sensor in a predetermined time interval between the two-time intervals.

5. The touch input device of claim 4,
wherein the touch controller is configured to:
receive a vertical synchronization signal applied to the display panel;
generate at least one internal signal having a frequency corresponding to 1/N times (N is a natural number) of a frequency of the received vertical synchronization signal; and
control a timing of a driving signal for driving the touch sensor based on the generated internal signal.

6. The touch input device of claim 4 or 5,
wherein the touch controller is configured to control by dividing a time for driving the touch sensor and a time for driving or/and receiving a stylus within a predetermined time interval between the two time intervals, and
wherein the touch controller controls a stylus report rate of the stylus to be N times (N is a natural number greater than 1) faster than the touch report rate.

7. A touch input device (1') comprising a display panel (20), comprising:
a touch sensor (10') comprising a plurality of first electrodes (Rx0, Rx1, Rx2...) and a plurality of second electrodes (Tx0, Tx1, Tx2...) disposed to cross the plurality of first electrodes; and
a touch controller (15) electrically connected to the plurality of first electrodes and the plurality of second electrodes and configured to control the touch sensor,
wherein the second electrode (Tx0) comprises a pair of electrode parts (Tx0a, Tx0b), one (Tx0a) of the pair of electrode parts is disposed adjacent to at least one of the electrodes (Rx0) among the plurality of first electrodes, and the other (Tx0b) of the pair of electrode parts is disposed adjacent to at least one of remaining electrodes (Rx1) among the plurality of first electrodes,
wherein the touch controller (15) is configured to apply at least one driving signal to the plurality of second electrodes and to receive sensing signals from the plurality of first electrodes,
wherein the touch controller comprises a driving circuit unit (130") electrically connected to the plurality of second electrodes,
**characterised in that** the driving circuit unit (130") comprises a first switch element (SW1) configured to electrically connect or open the pair of electrode parts of each of the second electrodes,
wherein the driving circuit unit (130") comprises:
a second switch element (SW2) connected to one end of the first switch element;
a third switch element (SW3) connected to the other end of the first switch element;
a fourth switch element (SW4) connected between the second switch element and an AC ground; and
a fifth switch element (SW5) connected between the third switch element and the AC ground.

8. A touch input device (1') comprising a display panel (20), comprising:
a touch sensor (10') comprising a plurality of first electrodes (Rx0, Rx1, Rx2...) and a plurality of second electrodes (Tx0, Tx1, Tx2...) disposed to cross the plurality of first electrodes; and
a touch controller (15) electrically connected to the plurality of first electrodes and the plurality of second electrodes and configured to control the touch sensor,
wherein the second electrode (Tx0) comprises a pair of electrode parts (Tx0a, Tx0b), one (Tx0a) of the pair of electrode parts is disposed adjacent to at least one of the electrodes (Rx0) among the plurality of first electrodes, and the other (Tx0b) of the pair of electrode parts is disposed adjacent to at least one of remaining electrodes (Rx1) among the plurality of first electrodes,
wherein the touch controller (15) is configured to apply at least one driving signal to the plurality of second electrodes and to receive sensing signals from the plurality of first electrodes,
wherein the touch controller comprises a driving circuit unit (130‴) electrically connected to the plurality of second electrodes, and
**characterised in that** the driving circuit unit (130‴) comprises:
a plurality of switching units (SPO, SP1, SP2, SP3...) electrically connected to the pair of electrode parts of the second electrode to electrically connect or open the pair of electrode parts to each other;
a multiplexer (M) configured to output two signals selected from among signals output from the plurality of switching units; and
a differential amplifier (DA) configured to differentially amplify the two signals output from the multiplexer and output the differentially amplified signals.

## Patentansprüche

1. Berührungseingabevorrichtung (1') mit einem Anzeigefeld (20), aufweisend:
einen Berührungssensor (10') mit einer Vielzahl von ersten Elektroden (Rx0, Rx1, Rx2...) und einer Vielzahl von zweiten Elektroden (Tx0, Tx1, Tx2...), die so angeordnet sind, dass sie sich mit der Vielzahl von ersten Elektroden kreuzen; und
eine Berührungssteuereinheit (15), die mit der Vielzahl von ersten Elektroden und der Vielzahl von zweiten Elektroden elektrisch verbunden und dafür ausgelegt ist, den Berührungssensor zu steuern,
wobei die zweite Elektrode (Tx0) ein Paar Elektrodenabschnitte (Tx0a, Tx0b) aufweist, wobei ein Elektrodenabschnitt (Tx0a) des Paars der Elektrodenabschnitte angrenzend an zumindest eine der Elektroden (Rx0) aus der Vielzahl von ersten Elektroden angeordnet ist, und der andere Elektrodenabschnitt (Tx0b) des Paars der Elektrodenabschnitte angrenzend an zumindest eine der verbleibenden Elektroden (Rx1) aus der Vielzahl von ersten Elektroden angeordnet ist,
wobei die Berührungssteuereinheit (15) dafür ausgelegt ist, zumindest ein Ansteuersignal an die Vielzahl von zweiten Elektroden anzulegen und Abfühlsignale von der Vielzahl von ersten Elektroden zu empfangen,
wobei die Berührungssteuereinheit (15) eine Ansteuerschaltungseinheit (130"") aufweist, die mit der Vielzahl von zweiten Elektroden elektrisch verbunden ist,
**dadurch gekennzeichnet, dass** die Ansteuerschaltungseinheit (130‴ʺ) aufweist:
einen Ansteuertreiber (D), der dafür ausgelegt ist, das Ansteuersignal zu verstärken und das verstärkte Signal an den einen Elektrodenabschnitt (Tx0a) des Paars der Elektrodenabschnitte der zweiten Elektrode auszugeben;
ein erstes Schaltelement (SW1), das dafür ausgelegt ist, den einen Elektrodenabschnitt (Tx0a) des Paars der Elektrodenabschnitte und den anderen Elektrodenabschnitt (Tx0b) des Paars der Elektrodenabschnitte elektrisch zu verbinden oder zu öffnen;
ein zweites Schaltelement (SW2), das zwischen dem Ansteuertreiber (D) und dem einen Elektrodenabschnitt (Tx0a) des Paars der Elektrodenabschnitte angeschlossen ist;
ein drittes Schaltelement (SW3), das mit dem einen Elektrodenabschnitt des Paars der Elektrodenabschnitte verbunden ist; und
ein analoges Empfangs-Frontend (Rx AFE), das mit dem dritten Schaltelement (SW3) verbunden ist.

2. Berührungseingabevorrichtung nach Anspruch 1,
wobei die Berührungssteuereinheit dafür ausgelegt ist, den Berührungssensor synchron mit zumindest einem horizontalen Synchronisationssignal anzusteuern, das an das Anzeigefeld angelegt wird, und den Berührungssensor für eine vorbestimmte Zeit anzusteuern, nachdem das horizontale Synchronisationssignal an das Anzeigefeld angelegt wurde.

3. Berührungseingabevorrichtung nach Anspruch 1 oder 2,
wobei die Berührungssteuereinheit eine Berührungsmelderate des Berührungssensors so steuert, dass sie der Bildwiederholfrequenz des Anzeigefelds entspricht.

4. Berührungseingabevorrichtung nach Anspruch 1 oder 2,
wobei die Berührungssteuereinheit dafür ausgelegt ist, den Berührungssensor in einem Zeitintervall anzusteuern, das sich von einem Zeitintervall unterscheidet, in dem horizontale Synchronisationssignale an das Anzeigefeld angelegt werden,
wobei die Berührungssteuereinheit eine Berührungsmelderate des Berührungssensor so steuert, dass sie höher ist als eine Bildwiederholrate des Anzeigefelds,
darüber hinaus eine Anzeigesteuerung aufweisend, die dafür ausgelegt ist, das Ansteuern des Anzeigefelds zu steuern,
wobei die Anzeigesteuerung dafür ausgelegt ist, das Anzeigefeld anzusteuern, indem das gesamte Zeitintervall, in dem die horizontalen Synchronisationssignale angelegt werden, in zumindest zwei Zeitintervalle unterteilt wird, und
wobei die Berührungssteuereinheit dafür ausgelegt ist, den Berührungssensor in einem vorbestimmten Zeitintervall zwischen den zwei Zeitintervallen anzusteuern.

5. Berührungseingabevorrichtung nach Anspruch 4,
wobei die Berührungssteuereinheit für Folgendes ausgelegt ist:
Empfangen eines vertikalen Synchronisationssignals, das an Anzeigefeld angelegt wird;
Erzeugen von zumindest einem internen Signal mit einer Frequenz, die dem 1/N-fachen (N ist eine natürliche Zahl) einer Frequenz des empfangenen vertikalen Synchronisationssignals entspricht; und
Steuern eines Zeitablaufs eines Ansteuersignals zum Ansteuern des Berührungssensors beruhend auf dem erzeugten internen Signal.

6. Berührungseingabevorrichtung nach Anspruch 4 oder 5,
wobei die Berührungssteuereinheit dafür ausgelegt ist, die Steuerung auszuführen, indem eine Zeitspanne zum Ansteuern des Berührungssensors und eine Zeitspanne zum Ansteuern und/oder Empfangen eines Eingabestifts innerhalb eines vorbestimmten Zeitintervalls zwischen den zwei Zeitintervallen liegt, und
wobei die Berührungssteuereinheit eine Eingabestiftwiederholrate des Eingabestifts so steuert, dass sie N-mal (N ist eine natürliche Zahl größer als 1) höher ist als die Berührungsmelderate.

7. Berührungseingabevorrichtung (1') mit einem Anzeigefeld (20), aufweisend:
einen Berührungssensor (10') mit einer Vielzahl von ersten Elektroden (Rx0, Rx1, Rx2...) und einer Vielzahl von zweiten Elektroden (Tx0, Tx1, Tx2...), die so angeordnet sind, dass sie sich mit der Vielzahl von ersten Elektroden kreuzen; und
eine Berührungssteuereinheit (15), die mit der Vielzahl von ersten Elektroden und der Vielzahl von zweiten Elektroden elektrisch verbunden und dafür ausgelegt ist, den Berührungssensor zu steuern,
wobei die zweite Elektrode (Tx0) ein Paar Elektrodenabschnitte (Tx0a, Tx0b) aufweist, wobei ein Elektrodenabschnitt (Tx0a) des Paars der Elektrodenabschnitte angrenzend an zumindest eine der Elektroden (Rx0) aus der Vielzahl von ersten Elektroden angeordnet ist, und der andere Elektrodenabschnitt (Tx0b) des Paars der Elektrodenabschnitte angrenzend an zumindest eine der verbleibenden Elektroden (Rx1) aus der Vielzahl von ersten Elektroden angeordnet ist,
wobei die Berührungssteuereinheit (15) dafür ausgelegt ist, zumindest ein Ansteuersignal an die Vielzahl von zweiten Elektroden anzulegen und Abfühlsignale von der Vielzahl von ersten Elektroden zu empfangen,
wobei die Berührungssteuereinheit eine Ansteuerschaltungseinheit (130") aufweist, die mit der Vielzahl von zweiten Elektroden elektrisch verbunden ist,
**dadurch gekennzeichnet, dass** die Ansteuerschaltungseinheit (130") ein erstes Schaltelement (SW1) aufweist, das dafür ausgelegt ist, das Paar der Elektrodenabschnitte von jeder der zweiten Elektroden elektrisch zu verbinden oder zu öffnen,
wobei die Ansteuerschaltungseinheit (130") aufweist:
ein zweites Schaltelement (SW2), das mit einem Ende des ersten Schaltelements verbunden ist;
ein drittes Schaltelement (SW3), das mit dem anderen Ende des ersten Schaltelements verbunden ist;
ein viertes Schaltelement (SW4), das zwischen dem zweiten Schaltelement und einer Wechselstrommasse angeschlossen ist; und
ein fünftes Schaltelement (SW5), das zwischen dem dritten Schaltelement und der Wechselstrommasse angeschlossen ist.

8. Berührungseingabevorrichtung (1') mit einem Anzeigefeld (20), aufweisend:
einen Berührungssensor (10') mit einer Vielzahl von ersten Elektroden (Rx0, Rx1, Rx2...) und einer Vielzahl von zweiten Elektroden (Tx0, Tx1, Tx2...), die so angeordnet sind, dass sie sich mit der Vielzahl von ersten Elektroden kreuzen; und
eine Berührungssteuereinheit (15), die mit der Vielzahl von ersten Elektroden und der Vielzahl von zweiten Elektroden elektrisch verbunden und dafür ausgelegt ist, den Berührungssensor zu steuern,
wobei die zweite Elektrode (Tx0) ein Paar Elektrodenabschnitte (Tx0a, Tx0b) aufweist, wobei ein Elektrodenabschnitt (Tx0a) des Paars der Elektrodenabschnitte angrenzend an zumindest eine der Elektroden (Rx0) aus der Vielzahl von ersten Elektroden angeordnet ist, und der andere Elektrodenabschnitt (Tx0b) des Paars der Elektrodenabschnitte angrenzend an zumindest eine der verbleibenden Elektroden (Rx1) aus der Vielzahl von ersten Elektroden angeordnet ist,
wobei die Berührungssteuereinheit (15) dafür ausgelegt ist, zumindest ein Ansteuersignal an die Vielzahl von zweiten Elektroden anzulegen und Abfühlsignale von der Vielzahl von ersten Elektroden zu empfangen,
wobei die Berührungssteuereinheit eine Ansteuerschaltungseinheit (130‴) aufweist, die mit der Vielzahl von zweiten Elektroden elektrisch verbunden ist, und
**dadurch gekennzeichnet, dass** die Ansteuerschaltungseinheit (130‴) aufweist:
eine Vielzahl von Schalteinheiten (SPO, SP1, SP2, SP3...), die mit dem Paar der Elektrodenabschnitte der zweiten Elektrode elektrisch verbunden sind, um das Paar der Elektrodenabschnitte miteinander zu verbinden oder zu öffnen;
einen Multiplexer (M), der dafür ausgelegt ist, zwei Signale auszugeben, die aus Signalen ausgewählt sind, die aus der Vielzahl von Schalteinheiten ausgegeben werden; und
einen Differentialverstärker (DA), der dafür ausgelegt ist, die zwei Signale, die aus dem Multiplexer ausgegeben werden, differentiell zu verstärken, und die differentiell verstärkten Signale auszugeben.

## Revendications

1. Dispositif de saisie tactile (1') comprenant un panneau d'affichage (20), comprenant :
un capteur tactile (10') comprenant une pluralité de premières électrodes (Rx0, Rx1, Rx2...) et une pluralité de deuxièmes électrodes (Tx0, Tx1, Tx2...) agencées de manière à croiser la pluralité de premières électrodes ; et
une unité de commande tactile (15), électriquement reliée à la pluralité de premières électrodes et à la pluralité de deuxièmes électrodes et configurée pour commander le capteur tactile,
dans lequel la deuxième électrode (Tx0) comprend une paire de sections d'électrode (Tx0a, Tx0b),une section d'électrode (Tx0a) de ladite paire de sections d'électrode étant disposée adjacente à au moins une électrode (Rx0) parmi la pluralité de premières électrodes, et l'autre section d'électrode (Tx0b) de ladite paire de sections d'électrode étant disposée adjacente à au moins une des électrodes restantes (Rx1) parmi la pluralité de premières électrodes,
dans lequel l'unité de commande tactile (15) est configurée pour appliquer au moins un signal de pilotage à la pluralité de deuxièmes électrodes et recevoir des signaux de détection provenant de la pluralité de premières électrodes,
dans lequel l'unité de commande tactile (15) comprend une unité de circuit de pilotage (130ʺʺ) électriquement reliée à la pluralité de deuxièmes électrodes,
**caractérisé en ce que** l'unité de circuit de pilotage (130‴ʺ) comprend :
un pilote d'excitation (D) configuré pour amplifier le signal de pilotage et fournir le signal amplifié à ladite une section d'électrode (Tx0a) de la paire de sections d'électrode de la deuxième électrode ;
un premier élément de commutation (SW1) configuré pour relier électriquement ou isoler ladite une section d'électrode (Tx0a) de la paire de sections d'électrode et ladite autre section d'électrode (Tx0b) de la paire de sections d'électrode ;
un deuxième élément de commutation (SW2) raccordé entre le pilote d'excitation (D) et ladite une section d'électrode (Tx0a) de la paire de sections d'électrode ;
un troisième élément de commutation (SW3) relié à ladite une section d'électrode de la paire de sections d'électrode ; et
un circuit frontal analogique de réception (Rx AFE) relié au troisième élément de commutation (SW3).

2. Le dispositif de saisie tactile selon la revendication 1,
dans lequel l'unité de commande tactile est configurée pour commander le capteur tactile en synchronisme avec au moins un signal de synchronisation horizontale appliqué au panneau d'affichage, et pour commander le capteur tactile pendant une durée prédéterminée après que le signal de synchronisation horizontale a été appliqué au panneau d'affichage.

3. Le dispositif de saisie tactile selon la revendication 1 ou 2,
dans lequel l'unité de commande tactile commande une fréquence de détection tactile du capteur tactile de manière à ce qu'elle corresponde à la fréquence de rafraîchissement du panneau d'affichage.

4. Le dispositif de saisie tactile selon la revendication 1 ou 2,
dans lequel l'unité de commande tactile est configurée pour commander le capteur tactile dans un intervalle de temps différent d'un intervalle de temps au cours duquel des signaux de synchronisation horizontale sont appliqués au panneau d'affichage,
dans lequel l'unité de commande tactile commande une fréquence de détection tactile du capteur tactile de manière à ce qu'elle soit supérieure à une fréquence de rafraîchissement du panneau d'affichage,
comprenant en outre une unité de commande d'affichage configurée pour commander le pilotage du panneau d'affichage,
dans lequel l'unité de commande d'affichage est configurée pour piloter le panneau d'affichage en divisant l'intégralité de l'intervalle de temps pendant lequel les signaux de synchronisation horizontale sont appliqués en au moins deux intervalles de temps, et
dans lequel l'unité de commande tactile est configurée pour piloter le capteur tactile dans un intervalle de temps prédéterminé entre les deux intervalles de temps.

5. Le dispositif de saisie tactile selon la revendication 4,
dans lequel l'unité de commande tactile est configurée pour :
recevoir un signal de synchronisation verticale appliqué au panneau d'affichage ;
générer au moins un signal interne ayant une fréquence correspondant à 1/N (N étant un nombre naturel) de la fréquence du signal de synchronisation verticale reçu ; et
commander une temporisation d'un signal de pilotage destiné à piloter le capteur tactile sur la base du signal interne généré.

6. Le dispositif de saisie tactile selon la revendication 4 ou 5,
dans lequel l'unité de commande tactile est configurée pour exécuter la commande de telle sorte qu'une période destinée à piloter le capteur tactile et une période destinée à piloter et/ou recevoir un stylet de saisie se situent dans un intervalle de temps prédéterminé entre les deux intervalles de temps, et
l'unité de commande tactile commandant une fréquence de répétition du stylet de saisie de manière à ce qu'elle soit N fois (N étant un nombre naturel supérieur à 1) plus élevée que la fréquence de détection tactile.

7. Le dispositif de saisie tactile (1') comprenant un panneau d'affichage (20), comprenant :
un capteur tactile (10') comprenant une pluralité de premières électrodes (Rx0, Rx1, Rx2...) et une pluralité de deuxièmes électrodes (Tx0, Tx1, Tx2...) agencées de manière à croiser la pluralité de premières électrodes ; et
une unité de commande tactile (15), électriquement reliée à la pluralité de premières électrodes et à la pluralité de deuxièmes électrodes et configurée pour commander le capteur tactile,
dans lequel la deuxième électrode (Tx0) comprend une paire de sections d'électrode (Tx0a, Tx0b),une section d'électrode (Tx0a) de ladite paire de sections d'électrode étant disposée adjacente à au moins une électrode (Rx0) parmi la pluralité de premières électrodes, et l'autre section d'électrode (Tx0b) de ladite paire de sections d'électrode étant disposée adjacente à au moins une des électrodes restantes (Rx1) parmi la pluralité de premières électrodes,
dans lequel l'unité de commande tactile (15) est configurée pour appliquer au moins un signal de pilotage à la pluralité de deuxièmes électrodes et recevoir des signaux de détection provenant de la pluralité de premières électrodes,
dans lequel l'unité de commande tactile comprend une unité de circuit de pilotage (130") électriquement reliée à la pluralité de deuxièmes électrodes,
**caractérisé en ce que** l'unité de circuit de pilotage (130") comprend un premier élément de commutation (SW1) configuré pour relier électriquement ou isoler la paire de sections d'électrode de chacune des deuxièmes électrodes,
dans lequel l'unité de circuit de pilotage (130") comprend :
un deuxième élément de commutation (SW2) relié à une extrémité du premier élément de commutation ;
un troisième élément de commutation (SW3) relié à l'autre extrémité du premier élément de commutation ;
un quatrième élément de commutation (SW4) raccordé entre le deuxième élément de commutation et une masse alternative ; et
un cinquième élément de commutation (SW5) raccordé entre le troisième élément de commutation et la masse alternative.

8. Le dispositif de saisie tactile (1') comprenant un panneau d'affichage (20), comprenant :
un capteur tactile (10') comprenant une pluralité de premières électrodes (Rx0, Rx1, Rx2...) et une pluralité de deuxièmes électrodes (Tx0, Tx1, Tx2...) agencées de manière à croiser la pluralité de premières électrodes ; et
une unité de commande tactile (15), électriquement reliée à la pluralité de premières électrodes et à la pluralité de deuxièmes électrodes et configurée pour commander le capteur tactile,
dans lequel la deuxième électrode (Tx0) comprend une paire de sections d'électrode (Tx0a, Tx0b),une section d'électrode (Tx0a) de ladite paire de sections d'électrode étant disposée adjacente à au moins une électrode (Rx0) parmi la pluralité de premières électrodes, et l'autre section d'électrode (Tx0b) de ladite paire de sections d'électrode étant disposée adjacente à au moins une des électrodes restantes (Rx1) parmi la pluralité de premières électrodes,
dans lequel l'unité de commande tactile (15) est configurée pour appliquer au moins un signal de pilotage à la pluralité de deuxièmes électrodes et recevoir des signaux de détection provenant de la pluralité de premières électrodes,
dans lequel l'unité de commande tactile comprend une unité de circuit de pilotage (130‴) électriquement reliée à la pluralité de deuxièmes électrodes, et
**caractérisé en ce que** l'unité de circuit de pilotage (130‴) comprend :
une pluralité d'unités de commutation (SPO, SP1, SP2, SP3...) électriquement reliées à la paire de sections d'électrode de la deuxième électrode afin de relier ou d'isoler l'une de l'autre ladite paire de sections d'électrode ;
un multiplexeur (M) configuré pour délivrer deux signaux sélectionnés parmi des signaux délivrés par la pluralité d'unités de commutation ; et
un amplificateur différentiel (DA) configuré pour amplifier de manière différentielle les deux signaux délivrés par le multiplexeur et délivrer les signaux amplifiés de manière différentielle.
